(19) Europäisches Patentamt
European Patent Office
Office européen des brevets

(11) EP 3 835 869 A1

(12) EUROPÄISCHE PATENTANMELDUNG

(43) Veröffentlichungstag:
16.06.2021 Patentblatt 2021/24

(21) Anmeldenummer: 19215470.6

(22) Anmeldetag: 12.12.2019

(51) Int Cl.:
G03F 7/004 (2006.01)    G03F 7/027 (2006.01)
G03F 7/029 (2006.01)    G03F 7/031 (2006.01)
G03F 7/095 (2006.01)    G03F 7/20 (2006.01)

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME
KH MA MD TN

(71) Anmelder: Flint Group Germany GmbH
70469 Stuttgart (DE)

(72) Erfinder:
• BEYER, Matthias
  69469 Weinheim (DE)

• BECKER, Armin
  67259 Grossniedesheim (DE)
• WENDLAND, Torben
  71272 Renningen (DE)
• Schlegel, Isabel
  76437 Rastatt (DE)
• FRONCZKIEWICZ, Peter J.
  Lake Wylie, SC 29710 (US)
• WUNDLING, Anja
  77866 Rheinau (DE)

(74) Vertreter: Arnold & Siedsma
Bezuidenhoutseweg 57
2594 AC The Hague (NL)

(54) **FOTOPOLYMERISIERBARER RELIEFVORLÄUFER MIT EINSTELLBAREN OBERFLÄCHENEIGENSCHAFTEN**

(57) Die Erfindung betrifft einen fotopolymerisierbaren Reliefvorläufer umfassend

(A) einen dimensionsstabilen Träger,

(B) eine fotopolymerisierbare reliefbildende Schicht, mindestens enthaltend ein vernetzbares elastomeres Bindemittel, ein ethylenisch ungesättigtes Monomer, ein migrationsfähiges, oberflächenaktives Additiv, einen mit UVA-Licht aktivierbaren Photoinitiator und einen mit UVC-Licht aktivierbaren Photoinitiator.

Die Erfindung betrifft weiterhin ein Verfahren zur Herstellung einer Reliefstruktur mit den Schritten:

(i) Bereitstellen eines fotopolymerisierbaren Reliefvorläufers enthaltend mindestens ein migrationsfähiges, oberflächenaktives Additiv,

(ii) Aufbringen einer Maske oder Erzeugung einer strukturierten Maskenschicht oberhalb der fotopolymerisierbaren reliefbildenden Schicht,

(iii) optional Rückseitenvorbelichtung mit elektromagnetischer Strahlung durch die Trägerschicht,

(iv-a) Belichtung der fotopolymerisierbaren reliefbildenden Schicht mit elektromagnetischer Strahlung durch die Maske oder Maskenschicht hindurch,

(v) Entfernung der Maske oder der Maskenschicht, gegebenenfalls vorhandener weiterer Schichten und der in Schritt (iv-a) nicht belichteten, nicht fotopolymerisierten Bereiche der reliefbildenden Schicht, wobei ein Relief erzeugt wird,

(vi) optional Trocknung des Reliefs,

(vii) Nachbelichtung des Reliefs von der der Trägerschicht abgewandten Seite mit UVA-Licht im Wellenlängenbereich von 315 bis 380 nm und/oder mit UVC-Licht im Wellenlängenbereich von 200 bis 280 nm, wobei das Relief nachvernetzt und dessen Durchlässigkeit für das migrationsfähige oberflächenaktive Additiv eingestellt wird, zur Einstellung der Oberflächenbeschaffenheit des Reliefs,

(viii) optional weitere Behandlungsschritte.

EP 3 835 869 A1

**Beschreibung**

Die Erfindung betrifft einen fotopolymerisierbaren Reliefvorläufer mit durch die Belichtungsbedingungen einstellbaren Oberflächeneigenschaften, ein Verfahren zur Herstellung von Reliefstrukturen aus den Reliefvorläufern, die Reliefstrukturen selbst sowie deren Verwendung.

Druck mit Lösemittelfarbe erfordert eine farbabweisende Oberfläche der Druckplatte, um ein Zulaufen der Zwischenräume zwischen Rasterpunkten mit Farbe zu verhindern. Realisiert wird dies in der Regel durch die Gegenwart eines migrationsfähigen, oberflächenaktiven Additivs (MOA) in der Reliefschicht, das die Oberflächenspannung der druckenden Oberfläche senkt. Die Anwesenheit dieses Additivs kann jedoch beim Druck mit UV- oder Wasserfarben problematisch sein, da beispielsweise ein schlechter Farbübertrag in der Vollfläche resultiert. Daher werden zum Drucken mit Lösungsmittelfarbe, UV-Farbe oder wasserbasierter Farbe verschiedene Druckplatten verwendet.

Aufgabe der vorliegenden Erfindung ist es, eine Druckplatte bereitzustellen, die in der Weise "schaltbar" ist, dass ihre Oberflächeneigenschaften durch Belichtungsparameter eingestellt werden können, so dass die gleiche Druckplatte universell für verschiedene Einsatzbereiche verwendet werden kann. Unterschiedliche Anforderungen bestehen an Druckplatten, die mit Lösemittelfarben drucken einerseits, und an Druckplatten, die mit UV- oder Wasserfarbe drucken andererseits.

Gelöst wird die Aufgabe durch einen fotopolymerisierbaren Reliefvorläufer umfassend

(A) einen dimensionsstabilen Träger,

(B) eine fotopolymerisierbare reliefbildende Schicht, mindestens enthaltend ein vernetzbares elastomeres Bindemittel, ein ethylenisch ungesättigtes Monomer, ein migrationsfähiges, oberflächenaktives Additiv, einen mit UVA-Licht aktivierbaren Photoinitiator und einen mit UVC-Licht aktivierbaren Photoinitiator.

Mit den erfindungsgemäßen Reliefvorläufern ist es möglich, die Migration des MOA an die Oberfläche durch Wahl der Belichtungsparameter zu steuern. Dabei wird davon ausgegangen, dass das MOA das Bestreben hat, an die Oberfläche der Reliefschicht zu diffundieren und damit diese Oberfläche hydrophober zu machen. Eine Belichtung mit UVA-Licht mit höherer Eindringtiefe sorgt für eine stärkere Vernetzung in der ganzen Reliefschicht und stabilisiert das Relief insgesamt. Eine Belichtung mit UVC-Licht weist eine geringe Eindringtiefe in die photoaktive Schicht auf und sorgt für eine starke Nachvernetzung der noch vorhandenen Monomere und Polymere. Dadurch wird die Migration des MOA an die Oberfläche des Reliefs vermindert oder verhindert, was zu einer hydrophileren Oberfläche führt, die eine Benetzung der druckenden Flächen mit einer hydrophilen Druckfarbe begünstigt. Weiterhin kann die UVC-Belichtung die Oxidation von Formulierungsbestandteilen bewirken, was zur Bildung von polaren und hydrophilen Gruppen führt.

Mit erfindungsgemäßen Reliefvorläufern, die als Druckplatten Anwendung finden, lassen sich unter anderem folgende Vorteile realisieren:

Die Oberflächeneigenschaften lassen sich so einstellen, dass das Zulaufen der Zwischenräume zwischen den Rasterpunkten beim Drucken mit Lösungsmittelfarbe verhindert oder reduziert wird. Dadurch sind längere Druckzeiten möglich, bevor eine Reinigung der Platten erforderlich wird.

Durch Einstellung der Oberflächeneigenschaften lassen sich die Oberflächenklebrigkeit und so die Neigung zu Staub- und Schmutzanlagerungen auf der Oberfläche verringern.

Die gleiche Druckplatte kann zum Drucken mit verschiedenen Typen von Druckfarben eingesetzt werden, indem durch Wahl der Nachbelichtungsbedingungen die Oberflächeneigenschaften so eingestellt werden, dass die Druckplatte zum Drucken mit lösungsmittelbasierten Farben, wässrigen Farben oder UV-härtenden Farben geeignet ist.

Als dimensionsstabile Träger (A) können dimensionsstabile Trägermaterialien eingesetzt werden, die optional weitere Schichten aufweisen können. Beispiele geeigneter dimensionsstabiler Träger sind Platten, Folien sowie konische und zylindrische Röhren (Sleeves) aus Metallen wie Stahl, Aluminium, Kupfer oder Nickel oder aus Kunststoffen wie Polyethylenterephthalat, Polybutylenterephthalat, Polyamid und Polycarbonat, Geweben und Vliesen, wie Glasfasergewebe, sowie Verbundmaterialien aus Glasfasern und Kunststoffen. Als dimensionsstabile Träger kommen insbesondere dimensionsstabile Trägerfolien oder Metallbleche, beispielsweise Polyethylen- oder Polyesterfolien, Stahl- oder Aluminiumbleche in Frage. Diese Trägerfolien oder Bleche sind im Allgemeinen 50 bis 1100 $\mu$m, vorzugsweise 75 bis 400 $\mu$m, beispielsweise ca. 250 $\mu$m dick. Wird eine Kunststofffolie verwendet, liegt deren Dicke im Bereich von 100 bis 200 $\mu$m, bevorzugt von 125 bis 175 $\mu$m. Wird Stahl als Trägermaterial verwendet, sind Stahlbleche mit einer Dicke von 0,05 bis 0,3 mm bevorzugt. Zum Schutz gegen Korrosion werden bevorzugt verzinnte Stahlbleche verwendet. Diese Trägerfolien oder Trägerbleche können mit einer dünnen, haftvermittelnden Schicht, beispielsweise einer 0,05 bis 5 $\mu$m dicken Schicht, auf der der Substratschicht zugewandten Seite der Trägerfolie beschichtet sein. Diese Haftschicht kann beispielsweise aus einem Gemisch aus einem Polycarbonat, einem Phenoxyharz und einem multifunktionellen Isocyanat bestehen.

Diese Trägerfolien oder Trägerbleche können bereits mit einer dünnen haftvermittelnden Schicht (AH) ausgerüstet sein oder mit dieser versehen werden. Als Haftlackschichten können beispielsweise Polyurethanhaftlacke, (z. B.

gemäß DE3045516) auf Basis von polyisocyanatvernetzten Polyether- oder Polyesterlacken in Schichtdicken zwischen 0,1 und 50 μm, insbesondere zwischen 2 und 30 μm dienen.

Zusätzliche haftungsverbessernde Zwischenschichten (AH) können sich auf der von der Trägerschicht abgewandten Seite der Haftschicht befinden, weisen Schichtdicken zwischen 0,1 und 50, insbesondere 1 und 10 μm, auf und können beispielsweise aus verdünnter wässrig-alkoholischer Lösung von (zu beispielsweise 80 Mol%) teilverseiften Polyvinylester, Phenylglycerinethermonoacrylat und Glyoxal, Trocknen und Einbrennen erhalten werden.

Haftungsverbesserungsschichten oder Zwischenschichten sollen die Haftung zwischen einzelnen Schichten erhöhen und den Schichtaufbau stabilisieren. Hierbei sind Materialien zu wählen, die zu beiden Schichten eine Wechselwirkung aufbauen können. Bevorzugte Beispiele dafür sind Tenside, amphiphile Moleküle mit hydrophoben und hydrophilen Bereichen und Blockcopolymere. und Oligomere, die Blöcke enthalten, die mit den beiden Schichten kompatibel oder den Polymeren in den Schichten verträglich sind. Die Haftung zwischen dem dimensionsstabilen Träger (A) und der reliefbildenden Schicht (B) sollte dabei größer sein als 0,5 N/cm, wenn in einem Peeltest bei einem Abzugswinkel von 90° und einer Abzugsgeschwindigkeit von 30 mm/min gemessen wird.

Der Reliefvorläufer umfasst mindestens eine fotopolymerisierbare, reliefbildende Schicht (B). Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten oder elastische oder kompressible Unterschichten.

Die reliefbildende Schicht (B) kann auch aus mehr als einer Schicht bestehen, wobei sie im Allgemeinen 2 bis 20 Schichten, vorzugsweise 2 bis 5 Schichten, besonders bevorzugt 2 bis 3 Schichten, ganz besonders bevorzugt 2 Schichten umfasst. Die Schichten können die gleichen Bestandteilen oder unterschiedliche Bestandteile enthalten und dies in gleichen oder unterschiedlichen Anteilen. Vorzugsweise enthalten diese Schichten die gleichen Bestandteile. Vorzugsweise sind die reliefbildenden Schichten, die der Trägerschicht am nächsten liegen, bereits fixiert, vernetzt und/oder abreagiert. Auf diesen fixierten, vernetzten, abreagierten Schichten ist mindestens eine reliefbildende Schicht angeordnet, die noch fixiert, vernetzt werden oder abreagieren kann.

Elastomere Bindemittel zur Herstellung von reliefbildenden Schichten von Flexodruckelementen sind dem Fachmann bekannt. Als Beispiele seien Styrol-Dien-Blockcopolymere, Naturkautschuk, Polybutadien, Polyisopren, Styrol-Butadien-Kautschuk, Nitril-Butadien-Kautschuk, Butyl-Kautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln oder deren Gemischen löslich.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzweigte oder radiale Blockcopolymere handeln. Üblicherweise handelt es sich um Dreiblock-Copolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblock-Copolymere enthalten häufig gewisse Anteile an Zweiblock-Copolymeren. Die Dien-Einheiten können 1,2- oder 1,4-verknüpft sein. Es können sowohl Blockcopolymere vom Styrol-Butadien- oder vom Styrol-Isopren-Typ, als auch vom Styrol-Butadien- Isopren-Typ eingesetzt werden. Sie sind beispielsweise unter dem Namen Kraton© im Handel erhältlich. Weiterhin einsetzbar sind auch thermoplastisch elastomere Blockcopolymere mit Endblöcken aus Styrol und einem statistischen Styrol- Butadien-Mittelblock. Die Blockcopolymere können auch ganz oder teilweise hydriert sein, wie beispielsweise in SEBS-Kautschuken. Bevorzugte elastomere Bindemittel sind Dreiblock- Copolymere vom Typ A-B-A oder radiale Blockcopolymere vom Typ (AB)n, worin A Styrol und B ein Dien sind, sowie statistische Copolymere und Random- Copolymere aus Styrol und einem Dien.

In einer bevorzugten Ausführungsform der Erfindung handelt es sich bei den thermoplastisch elastomeren Bindemitteln um mindestens ein Styrol-Isopren-Blockcopolymer, insbesondere Styrol-Isopren-Styrol-Blockcopolymere, wobei die Polymere auch noch Anteile von Zweiblockcopolymeren Styrol-Isopren enthalten können. Bevorzugte Bindemittel vom Styrol-Isopren-Typ enthalten in der Regel 10 bis 30 Gew.-%, bevorzugt 12 bis 28 Gew.-% und besonders bevorzugt von 13 bis 25 Gew.-% Styrol. In einer weiteren Ausführungsform handelt es sich bei den Bindemitteln um Styrol-Butadien-Styrol- (SBS) Blockcopolymere. Bevorzugte SBS-Polymere enthalten in der Regel 20 bis 35 Gew.-%, bevorzugt 22 bis 33 Gew.-% und besonders bevorzugt von 24 bis 31 Gew.-% Styrol. Diese Blockcopolymere haben üblicherweise ein mittleres Molekulargewicht Mw (Gewichtsmittel) von 100 000 bis 300 000 g/mol. Selbstverständlich können auch Gemische verschiedener Styrol-Isopren- Blockcopolymere oder um Styrol-Butadien-Blockcopolymere verwendet werden.

In einer zweiten Ausführungsform der Erfindung können bevorzugt radiale Isopren-Styrol-Blockcopolymere eingesetzt werden. Die Isopren- und oder ButadienEinheiten in den Polyisopren-Blöcken können 1,4-verknüpft sein, d.h. die verbleibende Doppelbindung ist in der Kette angeordnet oder 3,4-verknüft, d.h. die verbleibende Doppelbindung ist seitenständig angeordnet. Es können Blockcopolymere eingesetzt werden, welche im Wesentlichen 1,4-Verknüpfungen aufweisen und Bindemittel, welche gewisse Anteile an 3,4-Verknüpfungen aufweisen. Die seitenständigen Vinylgruppen in Bindemitteln mit 3,4- verknüpften Einheiten können im Zuge der Vernetzung der fotopolymerisierbaren Schicht bevorzugt reagieren können und dementsprechend eine Platte mit hoher Vernetzung ergeben. Beispielsweise können Blockcopolymere eingesetzt werden, welche einen Vinylgruppengehalt von 20 bis 70 % aufweisen.

In einer bevorzugten Ausführungsform der Erfindung kann man ein radiales Styrol-Isopren-Copolymer einsetzen, welches einen Vinylgruppenanteil von weniger als 10 % aufweist. In einer zweiten bevorzugten Ausführungsform der Erfindung setzt man ein Gemisch von zwei verschiedenen Styrol-Isopren-Blockcopolymeren ein. Bevorzugt weist hierbei eines davon einen Vinylgruppengehalt von mindestens 20 % auf, insbesondere 20 bis 70 %, bevorzugt 25 bis 45 %. Das andere kann einen niedrigen Vinylgruppengehalt, beispielsweise einen von weniger als 10 % aufweisen. Weiterhin bevorzugt kann man ein Gemisch zweier Styrol-Isopren-Copolymere einsetzen, von denen eines einen hohen Diblockanteil von mehr als 40 Gew.-% aufweist und das zweite einen niedrigeren Diblockanteil von weniger als 30 Gew. %. Neben den genannten thermoplastisch-elastomeren Blockcopolymeren, insbesondere den Styrol-Isopren Blockcopolymeren kann die fotopolymerisierbare Schicht auch noch weitere, von den Blockcopolymeren verschiedene elastomere Bindemittel umfassen. Mit derartigen zusätzlichen Bindemitteln, auch sekundäre Bindemittel genannt, lassen sich die Eigenschaften der fotopolymerisierbaren Schicht modifizieren. Ein Beispiel für ein sekundäres Bindemittel sind Vinyltoluol-alpha-Methylstyrol-Copolymere. Im Regelfalle sollte die Menge derartiger sekundärer Bindemittel 25 Gew.-% bezüglich der Gesamtmenge aller eingesetzten Bindemittel nicht überschreiten. Bevorzugt übersteigt die Menge derartiger sekundärer Bindemittel nicht 15 Gew. %, besonders bevorzugt nicht 10 Gew.-%. Die Gesamtmenge an Bindemitteln beträgt üblicherweise 30 bis 90 Gew.-% bezüglich der Summe aller Bestandteile der reliefbildenden Schicht, bevorzugt 40 bis 85 Gew.-% und besonders bevorzugt 60 bis 85 Gew.-%.

Bei wässrig entwickelbaren Reliefvorläufern, werden wasserlösliche, quellbare, dispergierbare oder emulgierbare Polymere eingesetzt. Neben voll oder teilweise hydrolysierten Polyvinylacetaten, können Polyvinylalkohole, Polyvinylacetale, Polystyrolsulfonate, Polyurethane, Polyamide (wie sie beispielsweise in EP 0 085 472 oder in DE 1522444 beschrieben) und beliebige Kombinationen davon eingesetzt werden. Beispiele für derartige Polymere sind zu finden in EP 0 079 514, EP 0 224 164, oder EP 0 059 988. Diese Polymere können linear, verzweigt, sternförmig oder dendritisch sein und sowohl als Homopolymer, statistische Copolymere, Blockcopolymere oder alternierende Copolymere vorliegen. Sehr oft sind die genannten Polymeren mit funktionellen Gruppen versehen, die entweder die Löslichkeit erhöhen und/oder in Vernetzungsreaktionen teilnehmen können. Zu diesen Gruppen zählen beispielsweise Carboxy-, $SO_3$-, OH, Thiol-, ethylenisch ungesättigte, (Meth)acrylat-, Epoxid-Gruppen und beliebige Kombinationen davon.

Die Gesamtmenge an elastomeren Bindemitteln beträgt im Falle der reliefbildenden Schicht (B) üblicherweise 30 bis 90 Gew.-% bezüglich der Summe aller Bestandteile der reliefbildenden Schicht, bevorzugt 40 bis 85 Gew.-% und besonders bevorzugt 45 bis 85 Gew.-%.

Die reliefbildende Schicht (B) kann weitere Bestandteile enthalten, ausgewählt aus der Gruppe bestehend aus Weichmachern, Lösungsmitteln, weiteren Bindemitteln, farbgebenden Mitteln, Stabilisatoren, Reglern, UV-Absorbern, Dispergierhilfsmitteln, Vernetzern, Viskositätsmodifizierern, oberflächenaktiven Substanzen und beliebige Kombinationen davon. Diese Additive oder Hilfs- und Zusatzstoffe sind im strahlungsempfindlichen Gemisch in einer Gesamtkonzentration im Bereich von 0,001 bis 60 Gew.-%, bezogen auf die gesamte Formulierung, bevorzugt im Bereich von 0,01 bis 50 Gew.-%, besonders im Bereich von 0,1 bis 50 Gew.-%, ganz besonders im Bereich von 1 bis 50 Gew.-%, enthalten. Die einzelnen Additive sind dabei in Konzentrationen von 0,001 bis 40 Gew.-%, bezogen auf die gesamte Formulierung, bevorzugt im Bereich von 0,01 bis 40 Gew.-%, besonders im Bereich von 0,1 bis 40 Gew.-%, ganz besonders im Bereich von 0,1 bis 35 Gew.-%, enthalten.

Die fotopolymerisierbare reliefbildende Schicht (B) umfasst weiterhin in bekannter Art und Weise mindestens ein ethylenisch ungesättigtes Monomer, das mit dem oder den Bindemitteln verträglich ist. Bei dem ethylenisch ungesättigten Monomer kann sich auch um Mischungen von zwei oder mehr unterschiedlichen Monomeren handeln. Geeignete Verbindungen weisen mindestens eine olefinische Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure, Vinylether, Vinylester und Allylverbindungen erwiesen.

Im Allgemeinen sind diese Monomeren bei Raumtemperatur nicht gasförmige Verbindungen. Bevorzugt enthält das ethylenisch ungesättigte Monomer mindesten 2 ethylenisch ungesättigte Gruppen, besonders bevorzugt 2 bis 10 ethylenisch ungesättigte Gruppen, ganz besonders bevorzugt 2 bis 6 ethylenisch ungesättigte Gruppen. Auch Verbindungen mit C-C-Dreifachbindungen können im strahlungsempfindlichen Gemisch eingesetzt werden. Vorzugsweise handelt es sich bei der ethylenisch ungesättigten Gruppe um mindestens eine Acrylat- und/oder eine Methacrylatgruppe, es können jedoch auch Styrolderivate, Acrylamide, Vinylester und Vinylether zum Einsatz kommen. Das ethylenisch ungesättigte Monomer weist ein Molekulargewicht von im Allgemeinen kleiner als 600 g/mol, bevorzugt kleiner als 450 g/mol, besonders bevorzugt kleiner als 400 g/mol, ganz besonders bevorzugt kleiner als 350 g/mol und insbesondere kleiner als 300 g/mol auf.

In Frage kommen insbesondere Derivate der Acryl- und/oder Methacrylsäure, wie deren Ester mit ein- oder mehrwertigen Alkoholen, beispielsweise Acryl- oder Methacrylsäureester von Alkanolen mit 1 bis 20 Kohlenstoffatomen, wie Methylmethacrylat, Ethylacrylat, Propyl(meth)acrylat, Isopropyl(meth)acrylat, n-Butyl(meth)acrylat, Isobutyl(meth)acrylat, tert.-Butyl(meth)acrylat, Hexyl(meth)acrylat, Cyclohexyl(meth)acrylat, 2-Ethylhexyl(meth)acrylat, Lauryl(meth)acrylat, (Meth)acrylester mehrwertiger Alkohole mit 2 bis 20 Kohlenstoffatomen, z.B. 2-Hydroxyethyl(meth)acrylat, 2-Hydroxypropyl(meth)-acrylat, Ethylenglykoldi(meth)acrylat, Polyethylenglykoldi(meth)acrylat, Butandiol-1,4-di(meth)acrylat, Neopentylglykol-di(meth)acrylat, 3-Methylpentandioldi(meth)acrylat, 1,1,1-Trimethylolpropantri(meth)acrylat, 1,4-Butandioldiacrylat, 1,6-Hexandioldiacrylat, 1,6-Hexandioldimethacrylat, 1,9-Nonandioldiacrylat, Di-, Tri- und Tetraethylenglykoldi(meth)acrylat, Tripropylenglykol-di(meth)acrylat oder Pentaerythrittetra(meth)acrylat, des weiteren Poly(ethylenoxid)di(meth)acrylat, m-Methylpoly(ethylenoxid)-yl-(meth)acrylat, N,N-Diethylaminoethylacrylat, ein Umsetzungsprodukt aus 1 Mol Glycerin, 1 Mol Epichlorhydrin und 3 Mol Acrylsäure sowie Glycidylmethacrylat und Bisphenol-A-diglycidetheracrylat.

Ebenso eignen sich Derivate des Acrylamids und des Methacrylamids, wie z.B. Ether ihrer N-Methylolderivate mit ein- und mehrwertigen Alkoholen, z.B. Ethylenglykol, Glycerin, 1,1,1-Trimethylolpropan, oligomeren oder polymeren Ethylenoxid-Derivaten. Diese eignen sich besonders, wenn Polyamide oder Polyvinylalkohol als Bindemittel eingesetzt werden.

Geeignet sind auch sogenannte Epoxid- und Urethan(meth)acrylate, wie sie beispielsweise durch Umsetzung von Bisphenol-A-diglycidylether mit (Meth)acrylsäure oder durch Umsetzung von Diisocyanaten mit Hydroxyalkyl(meth)acrylaten oder mit hydroxylgruppenhaltigen Polyestern oder Polyethern erhalten werden können. Weiterhin einsetzbare olefinisch ungesättigte Verbindungen sind Ester der Acryl- oder Methacrylsäure, insbesondere solche mit niedrigem Dampfdruck und solche, die mit Verträglichkeitsvermittlern modifiziert sind, z.B. mit Hydroxy-, Amido-, Sulfoester- oder Sulfonamidgruppen. Auch Gemische der obengenannten copolymerisierbaren ethylenisch ungesättigten organischen Verbindungen können eingesetzt werden.

Bevorzugte ethylenisch ungesättigte Monomere sind Butandiol-1,4-di(meth)acrylat, Neopentylglykoldi(meth)acrylat, 3-Methylpentandioldi(meth)acrylat, 1,1,1-Trimethylolpropantri(meth)acrylat, 1,4-Butandioldiacrylat, 1,6-Hexandioldiacrylat, 1,6-Hexandioldimethacrylat, 1,9-Nonandioldiacrylat, Di-, Tri- und Tetraethylenglykoldi(meth)acrylat, Tripropylenglykoldi(meth)acrylat und Pentaerythrittetra(meth)acrylat.

In einer Ausführungsform ist das ethylenisch ungesättigte Monomer in einer Konzentration im Bereich von 0,5 bis 60 Gew%, bezogen auf die gesamte Formulierung, bevorzugt im Bereich von 1 bis 50 Gew.-%, besonders bevorzugt im Bereich von 1 bis 40 Gew.-%, ganz besonders bevorzugt im Bereich von 2 bis 40 Gew.-% enthalten.

Die fotopolymerisierbare, reliefbildende Schicht enthält weiterhin ein migrationsfähiges, oberflächenaktives Additiv.

Bevorzugte migrationsfähige, oberflächenaktive Additive sind ausgewählt aus der Gruppe bestehend aus ionischen oder nichtionischen Tensiden, langkettigen Kohlenwasserstoffen, Wachsen, insbesondere Paraffinwachsen, Organosiliziumverbindungen, insbesondere Silikonölen, Silanen und Siloxanen, oder deren Gemischen. Bei den Organosiliziumverbindungen kommen vor allem folgende in Frage: Polysiloxan-(Meth)acrylate, Polysiloxanamine, vinyl-terminierte Polysilane und Polysiloxane, Polyether-Polysiloxane sowie Mischungen davon. Beispielhafte Verbindungen aus den vorgenannten Klassen sind unter folgenden Handelsnamen erhältlich: Polyvest ST-E 100, Silico Glide T-41, Silico Glide T-57, AFCONA-3700, Silicon F. 1000, Silicon F. 60000, Rad 2010, Rad 2200N, Rad2300, Rad 2500, Rad2700, Rad 2800, Miramer SIU 2400, X-22-2445, X-22-174BX, KBM-5103, X-22-161B, KF-8010, Silmer OH ACR C50, Silmer OH ACR Di-400, Silmer ACR Di-10, Silmer OH ACR D4, AFCONA-3835 and Sartomer CN9800.

In einer bevorzugten Ausführungsform ist das migrationsfähige, oberflächenaktive Additiv ein Paraffinwachs. Bevorzugt sind verzweigte und/oder unverzweigte Paraffinwachse mit einer Kettenlänge von mehr als 15 C-Atomen, besonders bevorzugt von mehr als 20 C-Atomen und ganz besonders bevorzugt von mehr als 30 C-Atomen, weiterhin bevorzugt sind Kettenlängen im Bereich von 20 bis 40 C-Atomen.

Die fotopolymerisierbare, reliefbildende Schicht enthält weiterhin einen mit UVA-Licht aktivierbaren Photoinitiator und einen mit UVC-Licht aktivierbaren Photoinitiator.

Bevorzugte mit UVA-Licht aktivierbare Photoinitiatoren sind ausgewählt aus der Gruppe bestehend aus Benzilketalen, Acylphosphinoxiden, Bisacylphosphinoxiden, Aminophenylketonen, Phenyloximester und deren Gemischen.

Bevorzugte mit UVC-Licht aktivierbare Photoinitiatoren sind ausgewählt aus der Gruppe bestehend aus Hydroxyphenylketonen, Benzoylfomiaten, Benzophenonen, Arylalkylketonen, Arylbenzylketon und deren Gemischen.

In einer besonders bevorzugten Ausführungsform ist der mit UVA-Licht aktivierbare Photoinitiator ausgewählt aus der Gruppe bestehend aus Diphenyl(2,4,6-trimethylbenzoyl)phosphinoxid, Benzildimethylketal und Benzildiethylketal und der mit UVC-Licht aktivierbare Photoinitiator ist ausgewählt aus der Gruppe bestehend aus Oxyphenylessigsäure 2-[2-oxo-2-phenylacetoxyethoxy]ethylester, Oxyphenylessigsäure 2-[2-hydroxyethoxy]ethylester, Methylbenzoylformiat, p-Tolylundecylketon, 1-Hydroxycyclohexylphenylketon und 2-Hydroxy-2-methyl-1-phenylpropan-1-on und deren Gemischen.

Das migrationsfähige, oberflächenaktive Additiv ist im Allgemeinen in einer Menge von 0,1 bis 10 Gew.-%, bevorzugt 0,2 bis 5 Gew.-%, besonders bevorzugt 0,5 bis 1,5 Gew.-%, bezogen auf das Gewicht der fotopolymerisierbaren, reliefbildenden Schicht, in der fotopolymerisierbaren, reliefbildenden Schicht enthalten.

Der mit UVA-Licht aktivierbare Photoinitiator ist im Allgemeinen in einer Menge von 0,5 bis 20 Gew.-%, bevorzugt von 0,5 bis 15 Gew.-%, besonders bevorzugt von 0,5 bis 10 Gew.-%, ganz besonders bevorzugt von 0,5 bis 6 Gew.-%, bezogen auf die Gesamtmenge der fotopolymerisierbaren, reliefbildenden Schicht, in der fotopolymerisierbaren, reliefbildenden Schicht enthalten.

Der mit UVC-Licht aktivierbare Photoinitiator ist im Allgemeinen in einer Konzentration von 0,1 bis 20 Gew.-%, bevorzugt von 0,1 bis 10 Gew.-%, besonders bevorzugt von 0,5 bis 5 Gew.-%, ganz besonders bevorzugt von 0,25 bis 3 Gew.-%, bezogen auf die Gesamtmenge der fotopolymerisierbaren, reliefbildenden Schicht, in der fotopolymerisierbaren, reliefbildenden Schicht enthalten.

Im Allgemeinen beträgt das Massenverhältnis von mit UVA-Licht aktivierbarem Photoinitiator zu mit UVC-Licht aktivierbarem Photoinitiator von 0,1 bis 50, bevorzugt von 0,5 bis 40, besonders bevorzugt von 0,5 bis 30, ganz besonders bevorzugt von 0,5 bis 15.

Im Allgemeinen beträgt das Verhältnis der Menge von mit UVA-Licht aktivierbarem Photoinitiator zu migrationsfähigem, oberflächenaktivem Additiv von 0,01 bis 10, bevorzugt von 0,1 bis 5, besonders bevorzugt von 0,1 bis 3.

Der erfindungsgemäße fotopolymerisierbare Reliefvorläufer kann eine oder mehrere weitere Schichten aufweisen, ausgewählt aus der Gruppe bestehend aus einer Haftschicht und/oder einer kompressiblen Schicht zwischen der Trägerschicht und der reliefbildenden Schicht, einer oberhalb der reliefbildenden Schicht angeordneten funktionellen Schicht, beispielsweise einer strukturgebenden Schicht, einer Barriereschicht, einer Deckschicht und einer digital bebilderbaren Maskenschicht und Kombinationen von zwei oder mehr dieser Schichten.

Beispielsweise kann der fotopolymerisierbare Reliefvorläufer zwischen der Trägerschicht und der fotopolymerisierbaren reliefbildenden Schicht mindestens eine Zwischenschicht, vorzugsweise eine Haftschicht und/oder eine kompressible Schicht, aufweisen.

Der fotopolymerisierbare Reliefvorläufer kann auf der der Trägerschicht abgewandten Seite der fotopolymerisierbaren reliefbildenden Schicht eine weitere Schicht aufweisen, die ausgewählt aus der Gruppe bestehend aus einer Maskenschicht, einer Sperrschicht, einer Deckschicht und Kombinationen von zwei oder mehr dieser Schichten.

In einer bevorzugten Ausführungsform umfasst der fotopolymerisierbare Reliefvorläufer

(A) einen dimensionsstabilen Träger;
(AH) optional eine haftvermittelnde Schicht;
(B) eine fotopolymerisierbare reliefbildende Schicht, mindestens enthaltend ein vernetzbares elastomeres Bindemittel, ein ethylenisch ungesättigtes Monomer, ein migrationsfähiges, oberflächenaktives Additiv, einen mit UVA-Licht aktivierbaren Photoinitiator und einen mit UVC-Licht aktivierbaren Photoinitiator;
(C) eine laserablatierbare Maskenschicht, mindestens enthaltend ein nicht radikalisch vernetzbares elastisches Polymer, ein UVA-Licht absorbierendes Material und ein IR-Licht absorbierendes Material; und optional
(D) eine abziehbare Deckschicht.

Der erfindungsgemäße Reliefvorläufer enthält vorzugsweise eine über der reliefbildenden Schicht (B) angeordnete laserablatierbare Maskenschicht (C), die zudem mit Lösungsmitteln oder durch Erwärmen und Adsorbieren/Absorbieren entfernbar ist. Diese Schicht wird durch selektive Bestrahlung mittels hochenergetischer elektromagnetischer Strahlung erwärmt und verflüchtigt, wodurch eine bildhaft strukturierte Maske erzeugt wird, die zur Übertragung der Struktur auf den Reliefvorläufer genutzt wird. Dazu muss sie im UV-Bereich undurchlässig sein und im VIS-IR-Bereich Strahlung absorbieren, die zur Erwärmung der Schicht und ihrer Ablation führt.

Die optische Dichte der Maskenschicht im UV-Bereich von 330 bis 420 nm liegt dabei im Bereich von 1 bis 5, bevorzugt im Bereich von 1,5 bis 4, besonders bevorzug im Bereich von 2 bis 4. Die optische Dichte wird bestimmt, indem mit einem X-rite 361TX-Densitometer in der Einstellung *"Density"* mit UV-Filter gemessen wird.

Die Schichtdicke M der laserablatierbaren Maskenschicht (C) beträgt in der Regel 0,1 $\mu$m bis 5 $\mu$m. Bei Schichtdicken unterhalb von 0,1 $\mu$m ist es schwierig, eine ausreichende optische Dichte zu erreichen. Bei Schichtdicken von mehr als 5 $\mu$m ist die Laserempfindlichkeit des Elementes zu gering, so dass lange Laserzeiten zur Bebilderung notwendig sind. Bevorzugt beträgt die Schichtdicke 0,3 $\mu$m bis 4 $\mu$m, besonders bevorzugt 1 $\mu$m bis 3 $\mu$m. Die Laserempfindlichkeit der Maskenschicht (gemessen als die Energie, die notwendig ist, um 1 cm$^2$ Schicht zu ablatieren) sollte zwischen 0,1 und 10 J/cm$^2$, bevorzugt zwischen 0,3 und 5 J/cm$^2$, besonders bevorzugt zwischen 0,5 und 5 J/cm$^2$ liegen.

Die Maskenschicht (C) umfasst mindesten ein nicht radikal vernetzbares elastisches Polymer, das in der Lage ist, die Komponenten, die die elektromagnetische Strahlung absorbieren, gleichförmig zu verteilen und das bei Erwärmung möglichst effizient ablatiert wird. Das elastische Polymer kann ein lineares, verzweigtes, sternförmiges, kammförmiges, dendritisches Homo- oder Copolymer sein. Copolymere können als statistische und/oder Blockcopolymere vorliegen. Das elastische Polymer kann auch eine Mischung von verschiedenen Polymeren sein, die sich in beispielsweise in Struktur, Monomerzusammensetzung, Blocklängen, Molekulargewichten funktionellen Gruppen, ihrer Zahl und/oder Verteilung unterscheiden. Mischungen von Polymeren können ebenfalls verwendet werden.

Gut geeignete, nicht radikalisch vernetzbare, elastische Polymere für die Maskenschicht (C) sind beispielsweise Ethylenvinylacetate, weichelastische Polyamide, weichelastische Polyurethane, Nitrocellulose, Polyvinylacetale wie bei-

spielsweise Poly(vinybutralvinylalkohol)-Copolymere (oder Poly(vinlbutralvinylethyralvinylalkohol)-Copolymere. Selbstverständlich können auch andere weichelastische Materialien als Bindemittel eingesetzt werden, wie beispielsweise teilverseifte Polyvinylacetate. Bevorzugtes Bindemittel für die Maskenschicht (C) ist ein weichelastisches Polyamid, ein Polyvinylalkohol, ein teilverseiftes Polyvinylacetat oder ein teilverseiftes Polyvinylacetal.

Die Maskenschicht (C) kann dabei für Sauerstoff durchlässig oder undurchlässig sein.

Im Allgemeinen sind die reliefbildende Schicht (B) und die ablatierbare Maskenschicht (C) in den gängigen, kommerziell erhältlichen Auswaschmitteln, die in der Regel aus Lösungsmittelgemischen oder wässrigen Lösungen bestehen, löslich. Diese Auswaschmittel bestehen aus einem oder mehreren unpolaren Kohlenwasserstofflösungsmitteln als Hauptbestandteil und einem mäßig polaren Alkohol, beispielsweise Benzylalkohol, n-Pentanol, Cyclohexanol, Ethylhexanol oder Heptylalkoholen, als Nebenbestandteil. Wässrige Lösungen enthalten üblicherweise Tenside und/oder Flockungsmittel und haben in der Regel einen pH Wert > 7. Die reliefbildende Schicht (B) kann in diesen Auswaschmitteln in üblichen Zeiten verarbeitet werden.

Weiterhin können die reliefbildende Schicht (B) und die ablatierbare Maskenschicht (C) auch thermisch entwickelt bzw. entfernt werden (siehe beispielsweise EP 1 239 329 oder EP 1 170 121). Hierbei werden die Reliefstrukturen nach der bildmäßigen Belichtung bis zur Erweichungs- oder Schmelztemperatur erwärmt. Die unbelichteten und nicht vernetzten Bereiche der Reliefstruktur werden dadurch teilweise flüssig und klebrig und werden dann durch Aufsaugen (Absorption) mit einem Vlies oder einem Gewebe kontinuierlich entfernt.

In einer weiteren Ausführungsform liegt im erfindungsgemäßen Reliefvorläufer zwischen den Schichten (B) und (C) eine weitere Schicht (E) vor, die für Sauerstoff undurchlässig ist. Wenn eine sauerstoffundurchlässige Schicht (E) vorliegt, sind die Schichten (B) und/oder (C) vorzugsweise durchlässig für Sauerstoff. Die Schichtdicke der Schicht (E) liegt dabei im Bereich von 3 bis 5 $\mu$m. Die Schicht enthält neben Zusatzstoffen hauptsächlich ein oder mehrere elastische Polymere, die eine geringe Sauerstoffpermeabilität aufweisen, wobei diese eine Sauerstoffpermeabilität mit einen Wert von kleiner gleich $1,5*10^5$ cm$^3$*$\mu$m/(m$^2$*d*bar) aufweisen. Vorzugsweise sind die Polymere in der Schicht (E) ebenfalls nicht radikalisch vernetzbar.

Geeignete elastische Polymere, die in organischen Lösungsmitteln löslich sind und/oder sich thermisch entwickeln lassen und eine ausreichende Sperrwirkung gegen Sauerstoff besitzen, sind beispielsweise teilverseifte Polyvinylacetate mit einem Verseifungsgrad zwischen 30 und maximal 80 Mol-%, Ethylen-VinylacetatCopolymere und Ethylen-Vinylalkohol-Copolymere und Ethylen-Vinylacetat-Vinylalkohol-Copolymere. Gut geeignet sind auch cyclische Acetale von Polyvinylalkohol wie Polyvinylbutyral, Polyvinylethyral, Polyvinylformal, Polyvinylpropyral sowie Copolymere, die zwei oder mehr verschiedene Vinylacetal-Einheiten, ausgewählt aus Vinylformal-, Vinylethyral-, Vinylpropyral- und Vinylbutyral-Einheiten, enthalten. Bei den Polyvinylacetalen handelt es sich immer um Copolymere mit Vinylalkoholeinheiten, da die Umsetzung von Polyvinylalkohol zum Vollacetal aus statistischen und sterischen Gründen nicht vollständig ist. So handelt es sich bei Poly(vinylbutyral) genau genommen um ein Poly(vinlbutralvinylalkohol). Üblicherweise liegt der Rest-OH-Gehalt der genannten Polyvinylacetale zwischen 10 und 30 Gew.-%. Sehr gut geeignet sind beispielsweise Vinylethyralvinylbutyral-vinylalkohol-Copolymere (Poly(vinylethyralvinylbutyral).

Gegenstand der Erfindung ist auch ein Verfahren zur Herstellung einer Reliefstruktur mit den Schritten:

(i) Bereitstellen eines fotopolymerisierbaren Reliefvorläufers enthaltend mindestens ein migrationsfähiges, oberflächenaktives Additiv,

(ii) Aufbringen einer Maske oder Erzeugung einer strukturierten Maskenschicht oberhalb der fotopolymerisierbaren reliefbildenden Schicht,

(iii) optional Rückseitenvorbelichtung mit elektromagnetischer Strahlung durch die Trägerschicht,

(iv-a) Belichtung der fotopolymerisierbaren reliefbildenden Schicht mit elektromagnetischer Strahlung, vorzugsweise im Wellenlängenbereich von 315 bis 380 nm, durch die Maske oder Maskenschicht hindurch,

(v) Entfernung der Maske oder der Maskenschicht, gegebenenfalls vorhandener weiterer Schichten und der in Schritt (iv) nicht belichteten, nicht fotopolymerisierten Bereiche der reliefbildenden Schicht, wobei eine Relief erzeugt wird,

(vi) optional Trocknung des Reliefs,

(vii) Nachbelichtung des Reliefs von der der Trägerschicht abgewandten Seite mit UVA-Licht im Wellenlängenbereich von 315 bis 380 nm und/oder mit UVC-Licht im Wellenlängenbereich von 200 bis 280 nm, wobei das Relief nachvernetzt und dessen Durchlässigkeit für das migrationsfähige oberflächenaktive Additiv eingestellt wird, zur Einstellung der Oberflächenbeschaffenheit des Reliefs, vorzugsweise für den Einsatz spezifischer Druckfarben,

(viii) optional weitere Behandlungsschritte.

Gegenstand der Erfindung ist weiterhin ein Verfahren zur Herstellung einer Reliefstruktur mit den Schritten:

(i) Bereitstellen eines fotopolymerisierbaren Reliefvorläufers enthaltend mindestens ein migrationsfähiges, oberflächenaktives Additiv,

(iii) optional Rückseitenvorbelichtung mit elektromagnetischer Strahlung durch die Trägerschicht,

(iv-b) bildgebende Belichtung der fotopolymerisierbaren reliefbildenden Schicht mit elektromagnetischer Strahlung, vorzugsweise in einem Wellenlängenbereich von 315 bis 380 nm,

(v) Entfernung gegebenenfalls vorhandener weiterer Schichten und der in Schritt (iv) nicht belichteten, nicht fotopolymerisierten Bereiche der reliefbildenden Schicht, wobei eine Relief erzeugt wird,

(vi) optional Trocknung des Reliefs,

(vii) Nachbelichtung des Reliefs von der der Trägerschicht abgewandten Seite mit UVA-Licht im Wellenlängenbereich von 315 bis 380 nm und/oder mit UVC-Licht im Wellenlängenbereich von 200 bis 280 nm, wobei das Relief nachvernetzt und dessen Durchlässigkeit für das migrationsfähige oberflächenaktive Additiv eingestellt wird, zur Einstellung der Oberflächenbeschaffenheit des Reliefs, vorzugsweise für den Einsatz spezifischer Druckfarben,

(viii) optional weitere Behandlungsschritte.

In bevorzugten Ausführungsformen wird in Schritt (vii) mit UVA-Licht und UVC-Licht nachbelichtet. Dabei kann die Nachbelichtung mit UVA-Licht und UVC-Licht gleichzeitig (simultan), nacheinander oder abwechselnd (alternierend) erfolgen.

Wird mit UVA-Licht nachbelichtet, wird im Allgemeinen wird mit einer Dosis von 100 bis 30 000 mJ/cm$^2$ UVA-Licht nachbelichtet. Bevorzugt sind 100 bis 20000 mJ/cm$^2$, besonders bevorzugt sind 100 bis 7000 mJ/cm$^2$ UVA-Licht, ganz besonders bevorzugt sind 500 bis 7000 mJ/cm$^2$ UVA-Licht.

Wird mit UVC-Licht nachbelichtet, wird im Allgemeinen mit einer Dosis von 100 bis 20 000 mJ/cm$^2$ UVC-Licht nachbelichtet. Bevorzugt sind 100 bis 20000 mJ/cm$^2$, besonders bevorzugt 100 bis 8000 mJ/cm$^2$ UVC-Licht, ganz besonders bevorzugt 500 bis 8000 mJ/cm$^2$ UVC-Licht.

Es kann gleichzeitig, nacheinander oder abwechselnd mit UVA-Licht und UVC-Licht nachbelichtet werden, wobei das Verhältnis der Dosen von UVA- zu UVC-Licht ($D_{UVA} / D_{UVC}$) im Allgemeinen größer als 0,2, bevorzugt größer als 0,4, besonders bevorzugt größer als 0,6, ganz besonders bevorzugt größer als 0,8 ist. Während die Belichtung mit UVC-Licht aufgrund der geringeren Eindringtiefe vorzugsweise die Oberfläche der Schicht versiegelt, sorgt die Belichtung mit UVA-Licht durch eine stärkere Vernetzung in der ganzen Schicht, sodass mechanisch stabile Reliefs erhalten werden.

Im ersten Schritt (i) wird der zuvor beschriebene Reliefvorläufers bereitgestellt. Dieser kann optional gereinigt werden, wobei alle dem Fachmann geläufigen Methoden zum Einsatz kommen können, wie beispielsweise bürsten, abblasen, wischen (mit und ohne Lösemittel), abspülen und beliebige Kombinationen davon.

Die Wellenlänge der eingestrahlten elektromagnetischen Strahlung liegt dabei im Bereich von 200 bis 2000 nm, bevorzugt im UV-Bereich, besonders bevorzugt im Bereich von 200 bis 550 nm, ganz besonders bevorzugt im Bereich von 300 bis 450 nm. Neben breitbandiger Einstrahlung der elektromagnetischen Wellen kann es vorteilhaft sein schmalbandige oder monochromatische Wellenlängenbereiche zu verwenden, wie sie unter Einsatz von entsprechenden Filtern, Lasern oder Light Emitting Diodes (LEDs) erzeugt werden können. In diesen Fällen sind Wellenlängen in den Bereichen 350, 365, 385, 395, 400, 405, 532, 830, 1064 nm einzeln (und ca. 5-10 nm darüber und/oder darunter) oder als Kombinationen bevorzugt.

Bei Vorliegen einer Deckschicht (D) wird diese entfernt. Vorzugsweise ist die Deckschicht eine Schutzfolie und wird abgezogen.

Im Schritt (ii) erfolgt die Bebilderung der Maskenschicht entweder durch eine Entfernung der Schicht und/oder eine ortsaufgelösten Veränderung der Absorptions- und/oder Reflexionseigenschaften so, dass die Maskenschicht im zur Bebilderung verwendeten Wellenlängenbereich zumindest teilweise transparent wird. Vorzugsweise wird die Maskenschicht mittels energiereicher Laser ablatiert, wobei Laserstrahlen computergesteuert über die Maskenschicht geführt werden. Hierbei kommen hauptsächlich IR-Laser mit Wellenlängen im Bereich von 500 bis 20 000 nm, vorzugsweise im Bereich von 800 bis 10 000 nm, besonders bevorzugt im Bereich von 1000 bis 2000 nm zum Einsatz. Insbesondere sind Wellenlängen um 830 nm, 980 nm, 1064 nm und 10,6 $\mu$m oder Kombinationen davon bevorzugt.

Im optionalen Schritt (iii) kann der Reliefvorläufer von mindestens einer Seite großflächig mit elektromagnetischer Strahlung bestrahlt werden. Diese Bestrahlung erfolgt vorzugsweise von der Seite des Reliefvorläufers, die der Maskenschicht gegenüber liegt, um eine Versockelung der zu erzeugenden Reliefstruktur zu erreichen (Rückseitenbelichtung). Vorzugsweise erfolgt diese Rückseitenbelichtung durch transparente dimensionsstabile Materialien wie beispielsweise Polymerfilme und insbesondere Polyesterfilme als Trägermaterial. Bei nicht transparenten Trägermaterialien entfällt Schritt (iii).

Durch das Belichten des erfindungsgemäßen Reliefvorläufers mit elektromagnetischer Strahlung in Schritt (iv-a) durch die Schicht (C) sowie gegebenenfalls (E) wird in den Bereichen der Schicht (B), die unter den ablatierten Flächen der Schicht (C) liegen, eine Reaktion ausgelöst, die zur Vernetzung der in der Schicht vorhandenen Bestandteile führt. Durch diese Vernetzung werden diese Bereiche stabilisiert und lassen sich im späteren Entwicklungsschritt nicht entfernen. Die Bestrahlung erfolgt im Allgemeinen großflächig, kann jedoch auch kleinflächig (annähernd punktförmig) mittels geführten Laserstrahlen oder ortsaufgelöster Projektion von elektromagnetischer Strahlung durchgeführt werden. Die zum Belichten verwendete elektromagnetische Strahlung weist im Allgemeinen Wellenlängen im Bereich von 200 bis 2000 nm, vorzugsweise im Bereich von 315 bis 380 nm auf.

Die Bestrahlung kann dabei kontinuierlich, gepulst oder in mehreren kurzen Perioden mit kontinuierlicher Strahlung erfolgen. Die Intensität der Strahlung kann dabei über einen weiten Bereich variiert werden, wobei sicher zu stellen ist, dass eine Dosis verwendet wird, die ausreicht, um die Schicht (B) für den späteren Entwicklungsvorgang ausreichend zu vernetzen. Die Intensität liegt im Allgemeinen im Bereich von 10 bis 1000 mW/cm$^2$. Die Dosis der Strahlung liegt im Allgemeinen im Bereich von 3 bis 100 J/cm$^2$, bevorzugt im Bereich von 6 bis 20 J/cm$^2$. Das Einwirken der Energiequelle kann auch in einer inerten Atmosphäre, beispielsweise in Edelgasen, $CO_2$ und/oder Stickstoff oder unter einer Flüssigkeit, die das Mehrschichtelement nicht beschädigt, durchgeführt werden.

Die direkte bildweise Belichtung kann dadurch erzielt werden, dass die zu vernetzenden Bereiche selektiv belichtet werden. Dies kann beispielsweise erreicht werden mit einem oder mehreren Laserstrahlen, welche entsprechend gesteuert werden, durch die Verwendung von Bildschirmen, bei welchen bestimmte Bildpunkte aktiviert werden, die Strahlung emittieren, durch Verwendung von verfahrbaren LED-Leisten, durch LED-Arrays, bei denen einzelne LEDs gezielt ein- und ausgeschaltet werden, durch die Verwendung von elektronisch steuerbare Masken, bei denen Bildpunkte transparent geschaltet werden, die die Strahlung einer Strahlungsquelle passieren lassen, durch die Verwendung von Projektionssystemen, bei welchen durch entsprechende Orientierung von Spiegeln Bildpunkte mit Strahlung einer Strahlungsquelle belichtet werden, oder Kombinationen davon. Bevorzugt erfolgt die direkte Belichtung mittels gesteuerter Laserstrahlen oder Projektionssystemen mit Spiegeln. Dabei müssen die Absorptionsspektren der Initiatoren oder Initiatorsysteme und die Emissionsspektren der Strahlungsquellen wenigstens teilweise überlappen.

In Schritt (v) werden die Schichten (C) und, falls vorhanden, die Schicht (E) sowie nicht vernetzte Bereiche der Schicht (B) entfernt und so das Relief erzeugt. Die nicht belichteten, nicht fotopolymerisierten Bereiche der reliefbildenden Schicht können in Schritt (v) durch Behandeln mit einem Auswaschmittel oder durch thermische Behandlung entfernt werden.

Die Schichten können einzeln oder in Gruppen oder alle zusammen und gleichzeitig entfernt werden. Vorzugsweise werden alle Schichten und die nicht vernetzten Bereiche von (B) in einem einzigen Schritt entfernt. Je nach Natur der Schichten kann das durch Behandlung mit lösungsmittel- oder wasserbasierten Auswaschmitteln, wie beispielsweise organischen Lösungsmitteln, deren Gemischen, Wasser, wässrigen Lösungen oder wässrig-organischen Lösungsmittelgemischen erfolgen, die in der Lage sind, nicht vernetzte Bereiche in der Schicht (B) zu lösen, zu emulgieren und/oder zu dispergieren.

In einer weiteren Ausführungsform erfolgt das Entfernen der Schichten (C) und falls vorhanden der Schicht (E) sowie der nicht vernetzten Bereiche der Schicht (B) in Schritt (v) thermisch, also durch Einbringen von Wärme und Entfernen des erweichten oder teilweise verflüssigten Materials der Schichten. Die Erwärmung des belichteten Reliefvorläufers kann mit allen dem Fachmann bekannten Methoden durchgeführt werden, wie beispielsweise durch Bestrahlung mit IR-Licht, Beaufschlagung mit heißen Gasen (z.B. Luft), mittels heißer Rollen oder beliebigen Kombinationen davon. Zur Entfernung der (zäh)flüssigen Bereiche können alle dem Fachmann geläufigen Verfahren und Methoden eingesetzt werden, wie beispielsweise Abblasen, Absaugen, Abtupfen, Abstrahlen (mit Partikeln und/oder Tröpfchen), Abstreifen, Abwischen, Übertragung auf ein Entwicklungsmedium und beliebige Kombinationen davon. Vorzugsweise wird das flüssige Material von einem Entwicklungsmedium aufgenommen (absorbiert und/oder adsorbiert), das kontinuierlich mit der erhitzten Oberfläche des Reliefvorläufers in Kontakt gebracht wird. Der Vorgang wird so oft wiederholt, bis die gewünschte Reliefhöhe erreicht ist. Als Entwicklungsmedien können Papiere, Gewebe, Vliese und Filme benutzt werden, die das verflüssigte Material aufnehmen können und aus Natur- und/oder Kunststofffasern bestehen können. Vorzugsweise werden Vliese oder nicht gewebte Faserbahnen aus Polymeren wie Cellulosen, Baumwolle, Polyestern, Polyamiden, Polyurethanen und beliebige Kombinationen davon verwendet, die bei den Temperaturen, die bei der Entwicklung angewendet werden, stabil sind.

Gegenstand der Erfindung ist auch ein Verfahren zur Herstellung einer optimierten Reliefstruktur, bei dem das Verfahren mit den Schritten (i) bis (viii) mehrfach durchgeführt wird, wobei in Schritt (vii) die Nachbelichtung mit UVA-Licht und/oder UVC-Licht hinsichtlich der Dosis und/oder der zeitlichen Abfolge der UVA- und UVC-Nachbelichtungsschritte variiert wird, um die Oberflächenbeschaffenheit des Reliefs zu optimieren.

Gegenstand der Erfindung sind auch die nach den vorstehend beschriebenen Verfahren erhältlichen Reliefstrukturen sowie deren Verwendung. Die Reliefstrukturen können als Tampondruckplatte, Flexodruckplatte, Buchdruckplatte, Tiefdruckplatte, mikrofluidisches Bauteil, Mikroreaktor, phoretische Zelle, photonischer Kristall oder optisches Bauteil verwendet werden. Bei mikrofluidischen Bauteilen oder Mikroreaktoren kann es vorteilhaft sein, die Oberflächeneigenschaften für die Verwendung von wässrigen oder stark polaren Fluiden hydrophob einzustellen, um die Wechselwirkungen mit den Wänden zu reduzieren oder beim Einsatz von unpolaren Fluiden eine hydrophile Oberfläche zu erzeugen. Bei phoretischen Zellen, photonischen Kristallen oder optischen Bauteilen kann es in Bezug auf Verschmutzung und Reinigung vorteilhaft sein, die Oberfläche hydrophob bzw. hydrophil einzustellen.

Die Erfindung wird durch die nachstehenden Beispiele näher erläutert.

Beispiele

Methoden:

Bewertung des Zulaufens

Zur Bewertung des Zulaufens wurden die Platten nach dem Druck von ca. 1000 Laufmetern beurteilt, indem die Tonwertfelder von 10% bis 50% beurteilt wurden. Eine starkes Zulaufen (viel Farbe in den Zwischenräumen) wurde mit "-" gekennzeichnet, geringes Zulaufen mit "0" und wenig bis gar nicht zugelaufen (keine Farbe in den Zwischenräumen) mit "+".

Methode zur Glanzmessung

Zum Nachweis eines migrationsfähigen, oberflächenaktiven Additives (MOA) auf der Plattenoberfläche wurden Glanzmessungen durchgeführt. Der Glanz wurde mit Hilfe eines micro-TRI-gloss $\mu$ Glanzmessgeräts (BYK -Gardner GmbH) bei einem Glanzwinkel von 60° gemessen. Das Glanzmessgerät wurde mit Hilfe des integrierten Kalibrierstandards vor den Messungen kalibriert. Das Ergebnis ist der Mittelwert aus je drei Messungen an verschiedenen Stellen auf der Plattenoberfläche. Entfernen des MOA durch Reinigen der Oberfläche mit Lösungsmittel führt zu einem Anstieg des Glanzes auf 40- 50 GU.

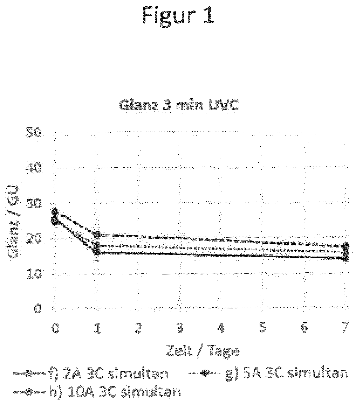

Die Figuren 1 bis 3 zeigen die Entwicklung des Glanzes in Glanzeinheiten GU in Abhängigkeit von der Zeit in Tagen für verschiedene Nachbelichtungszeiten.

Methode zur IR Messung

Zum Nachweis des MOA auf der Plattenoberfläche wurden FT-IR Messungen durchgeführt. Für die FT-IR Messungen an der Plattenoberfläche wurde ein Tensor 27 FT-IR (Bruker) verwendet, das mit einer PIKE MIRacle Diamant/ZnSe ATR-IR-Einheit (PIKE Technologies) ausgestattet war. Die Daten wurden mit Hilfe der Software Opus Version 7.5 (Bruker) aufgenommen und ausgewertet. Es erfolgte eine automatische Hintergrundkorrektur der Spektren. Als Maß für das Vorhandensein des MOA wurden die Integrale der IR-Banden bei 719 und 729 cm$^{-1}$ genutzt. Dazu wurden diese auf das Integral der IR-Bande bei 1730 cm$^{-1}$ normiert und der Nullwert (Ergebnis ohne MOA) subtrahiert. Die dem MOA zuzuordnenden Signale wurden durch IR-Spektroskopie der Reinsubstanz ermittelt. Bei Entfernen des MOA durch Reinigen der Oberfläche mit Lösungsmittel sind die dem MOA zuzuordnenden Signale im IR-Spektrum nicht mehr sichtbar.

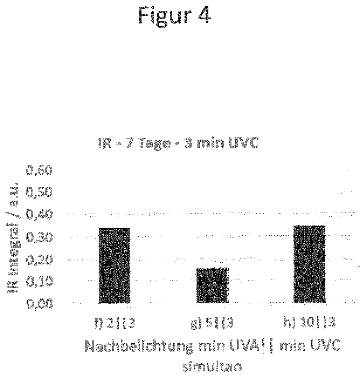

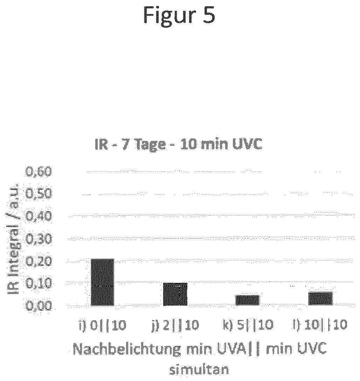

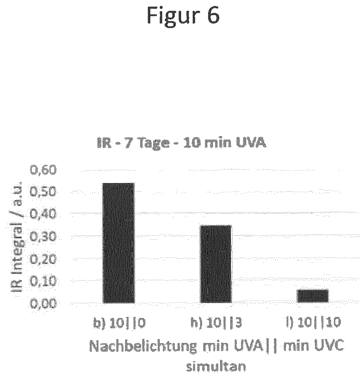

Die Figuren 4 bis 6 zeigen die Integrale der IR-Banden bei 719 und 729 cm$^{-1}$ nach 7 Tagen für die angegebenen Nachbelichtungszeiten.

Methode zur Kontaktwinkelmessung

Die Auswirkung des MOA auf die Benetzung der Oberfläche mit Wasser wurde mittels Kontaktwinkelmessungen untersucht. Dazu wurde ein Tropfen aus 10 $\mu$L VE-Wasser auf die Klischeeoberfläche einer Druckplatte getropft. Das Profil des Wassertropfens wurde mittels des Lichtmikroskops Keyence VHX-500F unter Verwendung des Objektivs VH-Z20R und des Stativs VH-S30 aufgenommen. Aus diesen Aufnahmen wurde mittels der dazugehörigen Software der Radius $r$ und die Höhe $h$ des Tropfens ausgemessen. Mittels Trigonometrie wurde der Kontaktwinkel $\theta$ berechnet (Gleichung 1).

$$\theta = \arccos\left(1 - \frac{h}{r}\right) \qquad (1)$$

Beispiel 1:

Ein SBS-basierter Reliefvorläufer (Gesamtdicke 1,14 mm) wurde mit 1 Gew% eines Paraffin-Wachses (>C20) mit einem Schmelzpunkt von 50-57°C als MOA und 2 Gew% Benzil-a,a-dimethylacetal (IGM Resins B.V.) auf einem Polyesterträger hergestellt. Der Reliefvorläufer wurde mittels der Fluoreszenzröhren (Philips TL 80W/10-R) in einem nyloflex® Combi FIII-Belichter (Flint Group) für 25 Sekunden mit einer Intensität von 16 mW/cm$^2$ von der Rückseite belichtet. Nach Abziehen der Schutzfolie wurde der Vorläufer in einem ThermoFlexX 20 (Xeikon) bebildert und anschließend in einem nyloflex® Combi FIII-Belichter (Flint Group) mittels der Fluoreszenzröhren (Philips TL 80W/10-R) für 15 Minuten mit einer Intensität von 16 mW/cm$^2$ bei 40°C durch die Maskenschicht belichtet. Der belichtete Vorläufer wurde in einem nyloflex® Digital Washer FIII (Flint Group) mittels nylosolv A und bei einer Geschwindigkeit von 220 mm/min ausgewaschen. Die Trocknung erfolgte über 120 Minuten bei 60°C. Anschließend wurden in einem nyloflex® Combi FIII-Belichter unterschiedliche Nachbelichtungen durchgeführt, wobei keine, nur UVA (Philips TL 60W/10-R, Intensität 11 mW/cm$^2$), nur UVC (Philips TUV 75W HO G75 T8, Intensität 13 mW/cm$^2$), sequenzielle und simultane UVA- und UVC-Belichtungen bei jeweils 40°C zum Einsatz kamen. Simultan bedeutet in diesem Zusammenhang, dass beide Belichtungen (mit UVA und UVC) zur selben Zeit gestartet werden. An den dabei gebildeten Druckflächen wurden anschließend in zeitlichen Abständen IR- und Glanz- Messungen durchgeführt. Die Referenz enthielt kein MOA. 1A bedeutet dabei 1 min Nachbelichtung mit UVA-Licht, 1C bedeutet 1 min Nachbelichtung mit UVC-Licht.

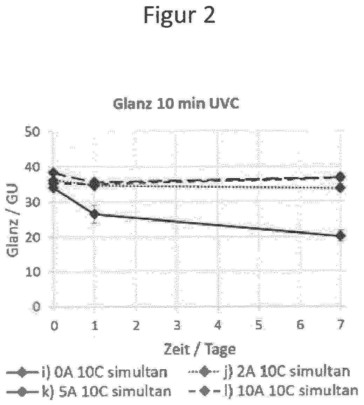

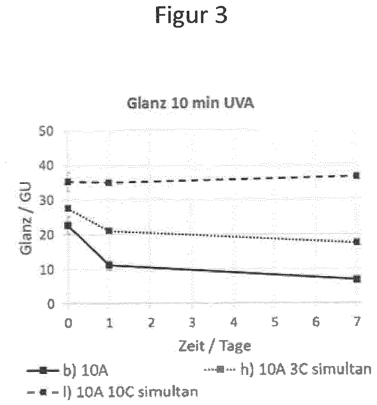

Die Figuren 1, 2 und 3 zeigen den zeitlichen Verlauf des Glanzes an den Oberflächen der Druckplatten bei verschiedenen Nachbelichtungsbedingungen. Diffundiert das MOA an die Oberfläche, nimmt der Glanzwert ab. Im Vergleich zu den Figuren 4, 5 und 6 ist festzustellen, dass eine Abnahme des Glanzwertes mit der Zunahme des IR-Signals einhergeht. Bei 3 min UVC-Nachbelichtung (Figur 1) ist noch kein eindeutiger Einfluss der UVA-Nachbelichtungszeit auf die MOA - Migration erkennbar. Bei 10 min UVC-Nachbelichtung (Figur 2) lässt sich die Menge an MOA mit zunehmender Nachbelichtungszeit deutlich reduzieren. Am Stärksten wirkt sich der Einfluss der UVC-Nachbelichtung in Kombination mit 10 min UVA-Nachbelichtung auf die Migration des MOA aus. Belichtet man 10 min mit UVA und 10 min UVC nach, so gelangt deutlich weniger MOA an die Druckoberfläche, als es für 10 min UVA-Nachbelichtungszeit ohne UVC-Belichtung der Fall ist (Figur 3). Die Eigenschaften der Druckoberfläche können somit gesteuert werden.

Tabelle 1: IR-Integrale und Glanz auf der Druckfläche nach 2 Tagen

| Beispiel | Bezeichnung | UVA Zeit (min) | UVA Dosis (mJ/cm$^2$) | UVC Zeit (min) | UVC Dosis (mJ/cm$^2$) | UVA/ UVC | IR (a.u.) | Glanz (GU) | 1 / Glanz (1/GU) |
|---|---|---|---|---|---|---|---|---|---|
| Referenz 1 | Kein MOA | 10 | 6600 | 0 | 0 | >100 | 0,00 | 41 | 0,025 |
| Beispiel 1a | Ohne Nachbelichtung | 0 | 0 | 0 | 0 | >100 | 0,71 | 16 | 0,062 |
| Beispiel 1b | 10A | 10 | 6600 | 0 | 0 | >100 | 0,32 | 12 | 0,086 |
| Beispiel 1c | 5C | 0 | 0 | 5 | 3900 | 0,0 | 0,05 | 32 | 0,031 |
| Beispiel 1d | 10A5C simultan | 10 | 6600 | 5 | 3900 | 1,7 | 0,08 | 32 | 0,031 |
| Beispiel 1e | 10A10C simultan | 10 | 6600 | 10 | 7800 | 0,8 | 0,02 | 35 | 0,028 |

Tabelle 1 zeigt die IR-Integrale und Glanz auf der Druckfläche nach 2 Tagen in Abhängigkeit von den Nachbelichtungsbedingungen. Je größer der Wert des IR-Integrals, desto mehr MOA ist auf der Plattenoberfläche vorhanden. Das IR-Integral korreliert mit dem Kehrwert des Glanzes. Ein niedriger Glanz belegt die Anwesenheit des MOA an der Oberfläche. Ohne MOA ist kein MOA mittels IR-Spektroskopie nachweisbar. Belichtet man mit 10 min mit UVA und 10 min UVC nach, so gelangt deutlich weniger MOA an die Druckoberfläche, als es ohne Nachbelichtung oder für 10 min UVA-Nachbelichtungszeit ohne UVC-Belichtung der Fall ist. Die Eigenschaften der Druckoberfläche können somit gesteuert werden.

Tabelle 2: IR-Integrale und Glanz auf der Druckfläche nach 7 Tagen

| Beispiel | Belichtung | UVA Zeit (min) | UVA Dosis (mJ/cm$^2$) | UVC Zeit (min) | UVC Dosis (mJ/cm$^2$) | UVA/ UVC | IR (a.u.) | Glanz (GU) | 1/Glanz (1/GU) |
|---|---|---|---|---|---|---|---|---|---|
| Referenz 1 | Kein MOA, 10A | 10 | 6600 | 0 | 0 | >100 | 0 | 40 | 0,025 |
| Beispiel 1a | Ohne Nachbelichtung | 0 | 0 | 0 | 0 | >100 | 0,79 | 9 | 0,107 |

(fortgesetzt)

| Beispiel | Belichtung | UVA Zeit (min) | UVA Dosis (mJ/cm$^2$) | UVC Zeit (min) | UVC Dosis (mJ/cm$^2$) | UVA/ UVC | IR (a.u.) | Glanz (GU) | 1/Glanz (1/GU) |
|---|---|---|---|---|---|---|---|---|---|
| Beispiel 1b | 10A | 10 | 6600 | 0 | 0 | >100 | 0,54 | 7 | 0,147 |
| Beispiel 1f | 2A3C simultan | 2 | 1320 | 3 | 2340 | 0,6 | 0,34 | 14 | 0,070 |
| Beispiel 1g | 5A3C simultan | 5 | 1500 | 3 | 2340 | 1,4 | 0,16 | 16 | 0,063 |
| Beispiel 1h | 10A3C simultan | 10 | 3000 | 3 | 2340 | 2,8 | 0,35 | 17 | 0,057 |
| Beispiel 1i | 10C | 0 | 0 | 10 | 7800 | 0,0 | 0,21 | 20 | 0,050 |
| Beispiel 1j | 2A10C simultan | 2 | 1320 | 10 | 7800 | 0,2 | 0,10 | 34 | 0,030 |
| Beispiel 1k | 5A10C simultan | 5 | 3300 | 10 | 7800 | 0,4 | 0,04 | 37 | 0,027 |
| Beispiel 1l | 10A10C simultan | 10 | 6600 | 10 | 7800 | 0,8 | 0,06 | 37 | 0,027 |

In Tabelle 2 ist der Einfluss der UVA- und der UVC-Belichtung auf die Präsenz des MOA auf der Klischee-Oberfläche zu erkennen. Die Dauer von 7 Tagen wurde gewählt, um zu belegen, dass das MOA tatsächlich nicht an die Oberfläche gelangt. Referenz 1 zeigt die Werte, die sich ohne MOA ergeben. Je weniger UVA- bzw. UVC-Licht auf Druckplatten mit MOA angewendet wurde, desto mehr MOA ist nach 7 Tagen auf der Klischee-Oberfläche vorhanden. Der Einfluss von UVC-Licht ist dabei stärker als der von UVA-Licht. Die Werte, die für die Kombination aus UVA- und UVC-Nachbelichtung erhalten wurden, entsprechen den Werten einer Druckplatte ohne MOA.

Beispiel 2:

a) Ein SIS-basierter Reliefvorläufer (Dicke: 1,14 mm) mit 1 Gew% eines Paraffin-Wachses (>C35) mit einem Schmelzpunkt von 58°C als MOA und 5 Gew% Benzil-$\alpha,\alpha$-dimethylacetal (IGM Resins B.V.) und 0,5 Gew% 1-Hydroxycyclohexylphenylketon (IGM Resins B.V.) wird auf einem Polyesterträger hergestellt.
b) ein zweiter Reliefvorläufer, jedoch ohne 1-Hydroxycyclohexylphenylketon wurde ebenfalls wie unter a) hergestellt.

Beide Plattentypen wurden mittels Fluoreszenzröhren (Philips TL 80W/10-R) in einem nyloflex® Combi FIII-Belichter (Flint Group) für 15 Sekunden (a)) bzw. für 10 Sekunden (b)) mit einer Intensität von 16 mW/cm$^2$ von der Rückseite belichtet. Nach Abziehen der Schutzfolie wurden die Vorläufer in einem ThermoFlexX 20 (Xeikon) bebildert und anschließend in einem nyloflex® Combi FIII-Belichter (Flint Group) mittels der Fluoreszenzröhren (Philips TL 80W/10-R) für 15 Minuten mit einer Intensität von 16 mW/cm$^2$ bei 40°C durch die Maskenschicht belichtet. Die Vorläufer wurden in einem nyloflex® Digital Washer FIII (Flint Group) mittels nylosolv A und bei einer Geschwindigkeit von 200 mm/min ausgewaschen. Die Trocknung erfolgte über 120 Minuten bei 60°C. Anschließend wurden in einem nyloflex® Combi FIII-Belichter (Flint Group) unterschiedliche Nachbelichtungen bei 40°C durchgeführt, wobei UVA- und UVC-Belichtungen parallel zum Einsatz kamen und gleichzeitig gestartet wurden. Einmal wurde 10 Minuten UVA (Philips TL 60W/10-R) mit einer Intensität von 11 mW/cm$^2$ und 3 Minuten UVC (Philips TUV 75W HO G75 T8) mit einer Intensität von 13 mW/cm$^2$ und das andere Mal 10 Minuten UVA und 10 Minuten UVC angewendet. An den dabei gebildeten, nicht druckenden Flächen (Floor) wurden anschließend in zeitlichen Abständen Glanzmessungen durchgeführt.

EP 3 835 869 A1

Tabelle 3: Glanz nach 3 Tagen und Zulaufen der Druckplatten mit Lösungsmittelfarbe (LM)

| | | Belichtung | Dosis UVA (mJ/cm$^2$) | Dosis UVC (mJ/cm$^2$) | UVA / UVC | Glanz (GU) | 1/Glanz (1/GU) | Zulaufen mit LM |
|---|---|---|---|---|---|---|---|---|
| | Referenz 1 | Kein MOA, 10A | 6600 | 0 | >100 | 130 | 0,008 | - |
| | Beispiel 2a | Ohne Nachbelichtung | 0 | 0 | >100 | 101 | 0,010 | + |
| | Beispiel 2b | 10A3Cp | 6600 | 2340 | 2,8 | 99 | 0,010 | + |
| | Beispiel 2c | 10A10Cp | 6600 | 7800 | 0,8 | 110 | 0,009 | - |

Tabelle 3 zeigt den Glanz auf der Oberfläche der Klischees nach 3 Tagen sowie das Zulaufen der Druckplatten nach dem Druck mit Lösungsmittelfarbe (LM). Ohne Nachbelichtung (Beispiel 2a) oder mit 10 min UVA- und 3 min UVC-Nachbelichtung (Beispiel 2b) wird ein geringerer Glanzwert als mit 10 min UVA- und 10 min UVC-Nachbelichtung (Beispiel 2c) beobachtet, der auf die Präsenz des MOA auf der Oberfläche des Floors hinweist. Im Druckversuch zeigen die Druckplatten aus Beispiel 2a und 2b ein vermindertes Zulaufen.

Beispiel 3:

a. Ein SBS-basierter Reliefvorläufer (Dicke 1,14 mm) mit 1 Gew% eines Paraffin-Wachses (>C35) mit einem Schmelzpunkt von 58°C als MOA und 2 Gew% Benzil-a,a-dimethylacetal (IGM Resins B.V.) wurde auf einem Polyesterträger hergestellt. Dieser wurde mittels eines Next FV-Belichters (Flint Group) mittels der Fluoreszenzröhren (Light Emission Tech F100T12/10-R 100W) für 26 Sekunden mit einer Intensität von 19 mW/cm$^2$ von der Rückseite belichtet. Nach Abziehen der Schutzfolie wurde der Vorläufer in einem CDI 2530 (Esko) bebildert und anschließend in einem Next FV-Belichter (Flint Group) mittels der Fluoreszenzröhren (Light Emission Tech F100T12/10-R 100W) für 10 Minuten mit einer Intensität von 19 mW/cm$^2$ durch die Maskenschicht belichtet. Der Vorläufer wurde in einem nyloflex Flowline Washer FV (Flint Group) mittels nylosolv A (Flint Group) und bei einer Geschwindigkeit von 255 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 10 Minuten, die UVC-Belichtungszeit wurde von 0 bis 10 Minuten in 2 Minutenabständen erhöht.

b. Ein SBS-basierter Reliefvorläufer (Dicke 1,14 mm) mit 1 Gew% eines Paraffin-Wachses (>C35) mit einem Schmelzpunkt von 58°C als MOA und 5 Gew% Benzil-a,a-dimethylacetal (IGM Resins B.V.) wurde auf einem Polyesterträger hergestellt. Dieser wurde mittels eines Next FV-Belichters (Flint Group) mittels der Fluoreszenzröhren (Light Emission Tech F100T12/10-R 100W) für 14 Sekunden mit einer Intensität von 19 mW/cm$^2$ von der Rückseite belichtet. Nach Abziehen der Schutzfolie wurde der Vorläufer in einem CDI 2530 (Esko) bebildert und anschließend in einem Next FV-Belichter (Flint Group) mittels der Fluoreszenzröhren (Light Emission Tech F100T12/10-R 100W) 8 Minuten mit einer Intensität von 19 mW/cm$^2$ durch die Maskenschicht belichtet. Der Vorläufer wurde in einem nyloflex Flowline Washer FV (Flint Group) mittels nylosolv A (Flint Group) und bei einer Geschwindigkeit von 285 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit wurde von 0 bis 10 Minuten in 2 Minutenabständen erhöht.

c. Ein SBS-basierter Reliefvorläufer (Dicke 1,14 mm) mit 1 Gew% eines Paraffin-Wachses (>C35) mit einem Schmelzpunkt von 58°C als MOA und 5 Gew% Benzil-a,a-dimethylacetal (IGM Resins B.V.) wurde auf einem Polyesterträger hergestellt. Dieser wurde mittels eines Next FV-Belichters (Flint Group) mittels der Fluoreszenzröhren (Light Emission Tech F100T12/10-R 100W) für 26 Sekunden mit einer Intensität von 19 mW/cm$^2$ von der Rückseite belichtet. Nach Abziehen der Schutzfolie wurde der Vorläufer in einem CDI 2530 (Esko) bebildert und anschließend in einem Next FV-Belichter (Flint Group) mittels der UV LED-Leiste mit 3 x 250 mm/min und einer Intensität von 800 mW/cm$^2$ durch die Maskenschicht belichtet. Der Vorläufer wurde in einem nyloflex Flowline Washer FV (Flint Group) mittels nylosolv A (Flint Group) und bei einer Geschwindigkeit von 255 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$)) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit wurde von 0 bis 10 Minuten in 2 Minutenabständen erhöht.

Druckparameter:

Eine Lösungsmittelfarbe Flexistar MV Process Cyan (Flint Group) wurde mittels einer F&K Flexpress 6S/8 Druckmaschine (Fischer & Krecke) auf eine einseitig Corona vorbehandelt LD-PE-Folie (Delo) mit 400 mm Breite und 55 μm Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$ versehen. Die Druckgeschwindigkeit betrug 200 m/min bei einer Beistellung von 70 μm für das Druckwerk und 60 μm für die Rasterwalze. Getrocknet wurde in 2 Stufen bei 40°C und 60°C.

Tabelle 4: Zulaufen der Druckplatte bei verschiedenen Verhältnissen an simultaner UVA- und UVC-Nachbelichtungen.

| Beispiel | UVA Bel. Zeit (min) | UVA Bel. Dosis (mJ/cm$^2$) | UVC Bel. Zeit | UVC Bel. Dosis | UVA/ UVC | Zulaufen mit LM Farbe |
|---|---|---|---|---|---|---|
| 3a | 10 | 7200 | 0 | 0 | >100 | + |
| | 10 | 7200 | 2 | 1320 | 5,5 | + |
| | 10 | 7200 | 4 | 2640 | 2,7 | 0 |
| | 10 | 7200 | 6 | 3960 | 1,8 | 0 |
| | 10 | 7200 | 8 | 5280 | 1,4 | - |
| | 10 | 7200 | 10 | 6600 | 1,1 | - |
| 3b | 8 | 5760 | 0 | 0 | >100 | + |
| | 8 | 5760 | 2 | 1320 | 4,4 | + |
| | 8 | 5760 | 4 | 2640 | 2,2 | 0 |
| | 8 | 5760 | 6 | 3960 | 1,5 | 0 |
| | 8 | 5760 | 8 | 5280 | 1,1 | - |
| | 8 | 5760 | 10 | 6600 | 0,9 | - |
| 3c | 8 | 5760 | 0 | 0 | >100 | + |
| | 8 | 5760 | 2 | 1320 | 4,4 | + |
| | 8 | 5760 | 4 | 2640 | 2,2 | 0 |
| | 8 | 5760 | 6 | 3960 | 1,5 | 0 |
| | 8 | 5760 | 8 | 5280 | 1,1 | - |
| | 8 | 5760 | 10 | 6600 | 0,9 | - |
| + = nicht zu gelaufen, 0 =wenig zugelaufen, - = stark zugelaufen | | | | | | |

Tabelle 4 zeigt die Bewertung des Zulaufens der Druckplatte nach Druck mit Lösungsmittelfarbe bei verschiedenen Verhältnissen von simultaner UVA- zu UVC-Nachbelichtung. Je höher die angewendete UVC-Nachbelichtungs-Dosis wurde, also je kleiner das Verhältnis der Dosen aus UVA- zu UVC-Nachbelichtung, desto stärker wurde ein Zulaufen der Zwischenräume der Druckplatte beobachtet. Bei geringer UVC-Nachbelichtungsdosis dagegen wird ein Zulaufen der Zwischenräume durch die Migration des MOA weitestgehend verhindert.

Beispiel 4:

MOA Migration

Ein SIS-basierter Reliefvorläufer (Dicke 1,14 mm) mit 1 Gew% eines Paraffin-Wachses (>C35) mit einem Schmelzpunkt von 58°C als MOA und 5 Gew% Benzil-$\alpha,\alpha$-dimethylacetal (IGM Resins B.V.) wurde auf einem Polyesterträger hergestellt. Dieser wurde mittels eines Combi FIII-Belichters (Flint Group) mittels Fluoreszenzröhren (Philips TL 60 W/10-R) mit einer Intensität von 28 mW/cm$^2$ für 14 Sekunden von der Rückseite belichtet. Nach Abziehen der Schutzfolie wurde der Vorläufer in einem CDI 2530 (Esko) bebildert und anschließend in einem Next FV-Belichter (Flint Group) mittels Fluoreszenzröhren (Light Emission Tech F100T12/10-R 100W) mit einer Intensität von 19 mW/cm$^2$ für 8 Minuten durch die Maskenschicht belichtet. Der Vorläufer wurde in einem nyloflex Flowline Washer FV (Flint Group) mittels nylosolv A (Flint Group) und bei einer Geschwindigkeit von 290 mm/min entwickelt. Die Trocknung erfolgte über 120 Minuten bei 60°C. Anschließend wurde bei Raumtemperatur nachbelichtet, wobei die UVA- (Philips TL 80 W/10-R SLV G13) mit einer Intensität von 12 mW/cm$^2$ und UVC-Belichtung (Philips TUV TL-D 95 W HO SLV/25) mit einer Intensität von 11 mW/cm$^2$ gleichzeitig gestartet und parallel durchgeführt wurden. Die UVA-Belichtungszeit betrug 8 Minuten, die UVC-Belichtungszeit 0 bzw. 2 Minuten.

Druckparameter UV-Farbe:

Für den Druck mit der UV-Farbe Flexocure Force (Flint Group) wurde eine Nilpeter Druckmaschine MO4 mit FA4 Flexo-Einheiten (Nilpeter) verwendet. Als Bedruckstoff wurde Selbstklebeetikettenmaterial auf PE-Basis (Raflatac) mit 330 mm Breite und 130 $\mu$m Dicke oder Papierbasis (Raflacoat, UPM) mit 330 mm Breite und 120 $\mu$m Dicke verwendet. Zur Befestigung der Druckplatten wurde ein Schaumklebeband Tesa Blue mit mittlerer Härte (Tesa) verwendet. Die verwendete Aniloxwalze war mit einer Rasterfeinheit von 500 Linien/cm und einem Volumen von 2,5 cm$^3$/m$^2$ versehen. Die Druckgeschwindigkeit betrug 100 m/min.

Tabelle 5: Auswirkungen des MOA im Druck mit UV-Farben auf PE-Folie oder Papier.

| Beispiel 4 | UVA Bel. Zeit (min) | UVA Bel. Dosis (mJ/cm$^2$) | UVC Bel. Zeit | UVC Bel. Dosis | UVA/ UVC | Vollton-Farbdichte | Anlaufkanten |
|---|---|---|---|---|---|---|---|
| PE-Folie | 8 | 5760 | 0 | 0 | >100 | 1,40 | Nicht bestimmt |
| | 8 | 5760 | 2 | 1320 | 4,4 | 1,34 | Nicht bestimmt |
| Papier | 8 | 5760 | 0 | 0 | >100 | Nicht bestimmt | Keine Anlaufkanten |
| | 8 | 5760 | 2 | 1320 | 4,4 | Nicht bestimmt | Starke Anlaufkanten |

Tabelle 5 zeigt die Auswirkungen des MOA im Druck mit UV-Farben auf PE-Folie oder Papier. Mit UVC-Nachbelichtung diffundiert weniger MOA an die Oberfläche der Druckplatte. Beim Druck auf PE-Folie wurde durch die Abwesenheit des MOA eine verringerte Vollton-Farbdichte, beim Druck auf Papier das Auftreten von Anlaufkanten beobachtet werden. Ohne UVC-Nachbelichtung diffundiert das MOA an die Oberfläche der Druckplatte und begünstigt den Farbübertrag auf den jeweiligen Bedruckstoff. Beim Druck auf PE-Folie wurde durch die Anwesenheit des MOA eine Erhöhung der Vollton-Farbdichte, beim Druck auf Papier ein Verschwinden der Anlaufkanten beobachtet.

Beispiel 5:

Ein SBS-basierter Reliefvorläufer (Dicke 1,14 mm) mit 0,1 oder 2,5 Gew% eines Paraffin-Wachses (>C35) mit einem Schmelzpunkt von 58°C als MOA, 5 Gew% Benzil-a,a-dimethylacetal (IGM Resins B.V.) wurde auf einem Polyesterträger hergestellt. Dieser wurde mittels eines Combi FIII-Belichters (Flint Group) mittels Fluoreszenzröhren (Philips TL 60 W/10-R) für 17 Sekunden mit einer Intensität von 28 mW/cm$^2$ von der Rückseite belichtet. Nach Abziehen der Schutzfolie wurde der Vorläufer in einem CDI 2530 (Esko) bebildert und anschließend in einem Combi FIII-Belichter (Flint Group) mittels der Fluoreszenzröhren (Philips TL 60 W/10-R) für 8 Minuten mit einer Intensität von 28 mW/cm$^2$ durch die Maskenschicht belichtet. Der Vorläufer wurde in einem nyloflex Flowline Washer FV (Flint Group) mittels Cyrel® Flexosol-i (DuPont) als Auswaschmittel bei einer Geschwindigkeit von 250 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit 2 Minuten.

Druckbedingungen:

Eine Lösungsmittelfarbe Flexistar MV Process Cyan (Flint Group) wurde mittels einer F&K Flexpress 6S/8 Druckmaschine (Fischer & Krecke) auf eine einseitig Corona vorbehandelt LD-PE-Folie (Delo) mit 400 mm Breite und 55 µm Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$ versehen. Die Druckgeschwindigkeit betrug 200 m/min.

Tabelle 6:

| Beispiel | Konz. MOA (%) | UVA Bel. Zeit (min) | UVA Bel. Dosis (mJ/cm$^2$) | UVC Bel. Zeit (min) | UVC Bel. Dosis (mJ/cm$^2$) | UVA/ UVC | Zulaufen |
|---|---|---|---|---|---|---|---|
| Referenz 5a | 0 | 8 | 5760 | 2 | 1320 | 4,4 | -- |
| Beispiel 5b | 1 | 8 | 5760 | 2 | 1320 | 4,4 | + |
| Beispiel 5c | 2,5 | 8 | 5760 | 2 | 1320 | 4,4 | + |
| Sehr starkes Zulaufen = -- <br> Starkes Zulaufen = - <br> Mäßiges Zulaufen = 0 <br> Kaum Zulaufen = + <br> Kein Zulaufen = ++ | | | | | | | |

Bei der Referenz 5a wird ein starkes Zulaufen der Platte beobachtet. Durch den Zusatz des MOA (Beispiele 5b und 5c) wurde das Zulaufen deutlich verringert (Tabelle 6).

Beispiel 6:

Ein SBS-basierter Reliefvorläufer (Dicke 1,14 mm) mit 1 Gew% eines Paraffin-Wachses (>C35) mit einem Schmelzpunkt von 58°C als MOA, 5 Gew% Benzil-$\alpha,\alpha$-dimethylacetal (IGM Resins B.V.) und 0%; 0,25% oder 0,5% eines 1-Hydroxycyclohexylphenylketons (C1) oder 0,5% einer Mischung aus Oxyphenylessigsäure 2-[2-oxo-2-phenylacetoxyethoxy]-ethylester und Oxyphenylessigsäure-2-[2-hydroxyethoxy]-ethylester (C2) (jeweils IGM Resins B.V.) wurde auf einem Polyesterträger hergestellt. Dieser wurde mittels eines Combi FIII-Belichters (Flint Group) mittels der Fluoreszenzröhren (Philips TL 60 W/10-R) für 22 Sekunden mit einer Intensität von 28 mW/cm$^2$ von der Rückseite belichtet. Nach Abziehen der Schutzfolie wurde der Vorläufer in einem CDI 2530 (Esko) bebildert und anschließend in einem Combi FIII-Belichter (Flint Group) mittels der Fluoreszenzröhren (Philips TL 60 W/10-R) für 10 Minuten mit einer Intensität von 28 mW/cm$^2$ durch die Maskenschicht belichtet. Der Vorläufer wurde in einem nyloflex Flowline Washer FV (Flint Group) mittels Cyrel® Flexosol-i (DuPont) als Auswaschmittel bei einer Geschwindigkeit von 250 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit 2 Minuten.

Druckbedingungen:

Eine Lösungsmittelfarbe Flexistar MV Process Cyan (Flint Group) wurde mittels einer F&K Flexpress 6S/8 Druckmaschine (Fischer & Krecke) auf eine einseitig Corona vorbehandelt LD-PE-Folie (Delo) mit 400 mm Breite und 55 µm Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$

versehen. Die Druckgeschwindigkeit betrug 200 m/min.

Tabelle 7:

| Beispiel | UVC Initiator | Konz. UVC Initiator (%) | UVA/UVC Initiator | Konz. MOA (%) | Zulaufen |
|---|---|---|---|---|---|
| Referenz 6a | - | 0 | - | 0 | -- |
| Beispiel 6b | - | 0 | - | 1 | 0 |
| Beispiel 6c | C1 | 0,05 | 100 | 1 | + |
| Beispiel 6d | C1 | 0,1 | 50 | 1 | + |
| Beispiel 6e | C1 | 0,2 | 25 | 1 | + |
| Beispiel 6f | C2 | 0,5 | 10 | 1 | + |
| Sehr starkes Zulaufen = --<br>Starkes Zulaufen = -<br>Mäßiges Zulaufen = 0<br>Kaum Zulaufen = +<br>Kein Zulaufen = ++ | | | | | |

Ohne MOA und ohne UVC-Photoinitiator (Referenz 6a) wird ein starkes Zulaufen der Platte beobachtet. Durch die Zugabe eines MOA und eines UVC-Photoinitiators wird das Zulaufen deutlich reduziert. Auch durch den Zusatz von 0,5% UVC-Photoinitiator C2 wird das Zulaufen bei dieser Plattenrezeptur reduziert (Tabelle 7).

Beispiel 7:

Ein SIS-basierter Reliefvorläufer (Dicke 1,14 mm) mit 1 Gew% eines Paraffin-Wachses (>C35) mit einem Schmelzpunkt von 58°C als MOA, 5 Gew% Benzil-$\alpha,\alpha$-dimethylacetal (IGM Resins B.V.) und 0%; 0,25% oder 0,5% eines 1-Hydroxycyclohexylphenylketons (C1) (IGM Resins B.V.) wurde auf einem Polyesterträger hergestellt. Dieser wurde mittels eines Combi FIII-Belichters (Flint Group) mittels der Fluoreszenzröhren (Philips TL 60 W/10-R) für 14 Sekunden mit einer Intensität von 28 mW/cm$^2$ von der Rückseite belichtet. Nach Abziehen der Schutzfolie wurde der Vorläufer in einem CDI 2530 (Esko) bebildert und anschließend in einem Combi FIII-Belichter (Flint Group) mittels der Fluoreszenzröhren (Philips TL 60 W/10-R) für 8 Minuten mit einer Intensität von 28 mW/cm$^2$ durch die Maskenschicht belichtet. Der Vorläufer wurde in einem nyloflex Flowline Washer FV (Flint Group) mittels Cyrel® Flexosol-i (DuPont) als Auswaschmittel bei einer Geschwindigkeit von 150 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit 2 Minuten.

Druckbedingungen:

Eine Lösungsmittelfarbe Flexistar MV Process Cyan (Flint Group) wurde mittels einer F&K Flexpress 6S/8 Druckmaschine (Fischer & Krecke) auf eine einseitig Corona-vorbehandelt LD-PE-Folie (Delo) mit 400 mm Breite und 55 $\mu$m Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$ versehen. Die Druckgeschwindigkeit betrug 200 m/min.

Tabelle 8:

| Beispiel | Konz. UVC Initiator C1 (%) | UVA/UVC Initiator | Konz. MOA (%) | Zulaufen |
|---|---|---|---|---|
| Referenz 7a | 0 | - | 1 | -- |
| Beispiel 7b | 0,25 | 8 | 1 | 0 |

(fortgesetzt)

| Beispiel | Konz. UVC Initiator C1 (%) | UVA/UVC Initiator | Konz. MOA (%) | Zulaufen |
|---|---|---|---|---|
| Beispiel 7c | 0,5 | 4 | 1 | + |
| Sehr starkes Zulaufen = --<br>Starkes Zulaufen = -<br>Mäßiges Zulaufen = 0<br>Kaum Zulaufen = +<br>Kein Zulaufen = ++ | | | | |

Das Zulaufen wird durch die Erhöhung des UVC-Photoinitiatorgehalts bei gleichbleibendem UVA-Photoinitiatorgehalt verringert. Mit 0,5% UVC-Photoinitiator (Beispiel 7c) wird kaum noch ein Zulaufen beobachtet (Tabelle 8).

Beispiel 8:

Ein SIS-basierter Reliefvorläufer (Dicke 1,70 mm) mit 1 Gew% eines Paraffin-Wachses (>C35) mit einem Schmelzpunkt von 58°C, 5 Gew% Benzil-$\alpha,\alpha$-dimethylacetal (IGM Resins B.V.) und 0%; 0,25% oder 0,5% eines 1-Hydroxycyclohexylphenylketons (C1) (IGM Resins B.V.) wurde auf einem Polyesterträger hergestellt. Dieser wurde mittels eines Combi FIII-Belichters (Flint Group) mittels der Fluoreszenzröhren (Philips TL 60 W/10-R) für 40 Sekunden mit einer Intensität von 28 mW/cm$^2$ von der Rückseite belichtet. Nach Abziehen der Schutzfolie wurde der Vorläufer in einem CDI 2530 (Esko) bebildert und anschließend in einem Combi FIII-Belichter (Flint Group) mittels der Fluoreszenzröhren (Philips TL 60 W/10-R) für 8 Minuten mit einer Intensität von 28 mW/cm$^2$ durch die Maskenschicht belichtet. Der Vorläufer wurde in einem nyloflex Flowline Washer FV (Flint Group) mittels Nylosolv A (Flint Group) als Auswaschmittel bei einer Geschwindigkeit von 230 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 8 Minuten, die UVC-Belichtungszeit 4 Minuten.

Druckbedingungen:

Eine Lösungsmittelfarbe Flexistar MV Process Cyan (Flint Group) wurde mittels einer F&K Flexpress 6S/8 Druckmaschine (Fischer & Krecke) auf eine einseitig Corona vorbehandelt LD-PE-Folie (Delo) mit 400 mm Breite und 55 $\mu$m Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$ versehen. Die Druckgeschwindigkeit betrug 200 m/min.

Tabelle 9:

| Beispiel | Konz. UVC Initiator C1 (%) | UVA/UVC Initiator | Konz. MOA (%) | Zulaufen |
|---|---|---|---|---|
| Referenz 8a | 0 | - | 0 | -- |
| Beispiel 8b | 0,5 | 10 | 1 | + |
| Beispiel 8c | 1,0 | 5 | 1 | + |
| Sehr starkes Zulaufen = --<br>Starkes Zulaufen = -<br>Mäßiges Zulaufen = 0<br>Kaum Zulaufen = +<br>Kein Zulaufen = ++ | | | | |

Im Vergleich zur Referenz 8a wurde das Zulaufen der Platte durch den Zusatz des MOA und des Photoinitiators C1 deutlich reduziert (Beispiele 8b und 8c). Durch die weitere Erhöhung des UVC-Photoinitiatorgehalts von 0,5% (Beispiel 8b) auf 1% (Beispiel 8c) wird keine weitere Verbesserung bezüglich des Zulaufens erhalten (Tabelle 9).

Beispiel 9:

Ein SBS-basierter Reliefvorläufer (Dicke 1,70 mm) mit 1 Gew% eines Paraffin-Wachses (>C35) mit einem Schmelzpunkt von 58°C, 1 Gew% Benzil-$\alpha,\alpha$-dimethylacetal (IGM Resins B.V.) und 0%; 0,5%; 1,0%; 1,5% oder 2,0% 1-(4-Methyllphenyl)-1-dodecanon (C3) (BASF) wurde auf einem Polyesterträger hergestellt. Dieser wurde mittels eines Combi FIII-Belichters (Flint Group) mittels der Fluoreszenzröhren (Philips TL 60 W/10-R) für 40 Sekunden mit einer Intensität von 28 mW/cm$^2$ von der Rückseite belichtet. Nach Abziehen der Schutzfolie wurde der Vorläufer in einem CDI 2530 (Esko) bebildert und anschließend in einem Combi FIII-Belichter (Flint Group) mittels der Fluoreszenzröhren (Philips TL 60 W/10-R) für 9 Minuten mit einer Intensität von 28 mW/cm$^2$ durch eine aufgelegte und durch Vakuum fixierte Maskenschicht belichtet. Der Vorläufer wurde nach Entfernen der Maskenschicht in einem nyloflex Flowline Washer FV (Flint Group) mittels Cyrel® Flexosol-i (DuPont) als Auswaschmittel bei einer Geschwindigkeit von 250 mm/min entwickelt. Die Trocknung erfolgte über 120 Minuten bei 60°C. Anschließend wurde bei Raumtemperatur nachbelichtet, wobei die UVA- (Philips TL 80W/10-R SLV G13, Intensität 12 mW/cm$^2$) und UVC-Belichtung (Philips TUV TL-D 95W HO SLV/25, Intensität 11 mW/cm$^2$) gleichzeitig gestartet und parallel durchgeführt wurden. Die UVA-Belichtungszeit betrug 10 Minuten, die UVC-Belichtungszeit 5 Minuten.

Druckbedingungen:

Eine Lösungsmittelfarbe Flexistar MV Process Cyan (Flint Group) wurde mittels einer F&K Flexpress 6S/8 Druckmaschine (Fischer & Krecke) auf eine einseitig Corona vorbehandelt LD-PE-Folie (Delo) mit 400 mm Breite und 55 $\mu$m Dicke gedruckt. Zur Befestigung der Druckplatten wurde ein Schaumklebeband Lohmann 5.3 (Lohmann) verwendet. Die verwendete Aniloxwalze war mit einer Rasterfeinheit von 420 Linien/cm und einem Volumen von 3,5 cm$^3$/m$^2$ versehen. Die Druckgeschwindigkeit betrug 200 m/min.

Tabelle 10:

| Beispiel | Konz. UVC Initiator C3 (%) | UVA/UVC Initiator | Konz. MOA (%) | Zulaufen |
|---|---|---|---|---|
| Referenz 9a | 0,0 | - | 1 | -- |
| Beispiel 9b | 0,5 | 2,0 | 1 | 0 |
| Beispiel 9c | 1,0 | 1,0 | 1 | + |
| Beispiel 9d | 1,5 | 0,7 | 1 | + |
| Beispiel 9e | 2,0 | 0,5 | 1 | + |
| Sehr starkes Zulaufen = --<br>Starkes Zulaufen = -<br>Mäßiges Zulaufen = 0<br>Kaum Zulaufen = +<br>Kein Zulaufen = ++ | | | | |

Bei der Referenz 9a wird ein starkes Zulaufen der Platte beobachtet. Durch den Zusatz des MOA und des Photoinitiators C3 wurde das Zulaufen deutlich verringert (Beispiele 9b bis 9e). Ab einer Konzentration von 1,0% des UVC-Photoinitiators C3 (Beispiel 9c) ist kaum noch ein Zulaufen zu beobachten. Gleiches gilt bei einer weiteren Erhöhung der UVC-Photoinitiatorkonzentration auf 1,5% bzw. auf 2,0% (Bespiele 9d und 9e) (Tabelle 10).

Beispiel 10:

Ein SIS-basierter Reliefvorläufer (Gesamtdicke 1,14 mm) wurde mit 1 Gew% eines Paraffin-Wachses (>C20) mit einem Schmelzpunkt von 50-57°C als MOA und 2 Gew% Benzil-a,a-dimethylacetal (IGM Resins B.V.) und 0% oder 0,5% 1-Hydroxycyclohexylphenylketon (IGM Resins B.V.) auf einem Polyesterträger hergestellt. Der Reliefvorläufer wurde mittels der Fluoreszenzröhren (Philips TL 80W/10-R) in einem nyloflex® Combi FIII-Belichter (Flint Group) für 10 Sekunden mit einer Intensität von 16 mW/cm$^2$ von der Rückseite belichtet. Nach Abziehen der Schutzfolie wurde der Vorläufer in einem ThermoFlexX 20 (Xeikon) bebildert und anschließend in einem nyloflex® Combi FIII-Belichter (Flint Group) mittels der Fluoreszenzröhren (Philips TL 80W/10-R) für 15 Minuten mit einer Intensität von 16 mW/cm$^2$ bei 40°C durch die Maskenschicht belichtet. Der belichtete Vorläufer wurde in einem nyloflex® Digital Washer FIII (Flint Group) mittels nylosolv A und bei einer Geschwindigkeit von 200 mm/min ausgewaschen. Die Trocknung erfolgte über 120 Minuten bei 60°C. Anschließend wurden in einem nyloflex® Combi FIII-Belichter unterschiedliche Nachbelichtungen durchgeführt, wobei nur UVA (Philips TL 60W/10-R, Intensität 11 mW/cm$^2$), nur UVC (Philips TUV 75W HO G75 T8, Intensität 13 mW/cm$^2$) oder simultane UVA- und UVC-Belichtungen bei jeweils 40°C zum Einsatz kamen. Simultan bedeutet in diesem Zusammenhang, dass beide Belichtungen (UVA und UVC) zur selben Zeit gestartet werden. Nach mindestens einer Woche Lagerzeit nach Entwicklung der Druckplatten wurden an den gebildeten Druckflächen Kontaktwinkelmessungen durchgeführt. Als Referenz diente eine Fläche aus reinem MOA, die durch Aufschmelzen und Erkalten desselbigen erhalten wurde.

Der Kontaktwinkel ist ein Maß für die Benetzung der Oberfläche. Die gleichmäßige Benetzung der Oberfläche mit Flüssigkeit (Druckfarbe) ist eine Grundvoraussetzung für den erfolgreichen Druckprozess. Ist keine vollständige Benetzung gegeben, ist auch keine vollständige Übertragung der Druckform auf den Bedruckstoff möglich. Entscheidend für die Benetzung ist der Unterschied der Oberflächenspannung der Druckfarbe zu der Oberflächenenergie der Druckplatte. Ein Tropfen Flüssigkeit auf einer Oberfläche zeigt einen großen Kontaktwinkel bei einem großen Unterschied zwischen Oberflächenspannung der Flüssigkeit und der Oberflächenenergie der Druckplatte. Bei einem geringen Unterschied erhält man eine gleichmäßige Benetzung der Oberfläche durch die Flüssigkeit und folglich einen kleinen Kontaktwinkel. MOA erzeugt eine hydrophobe Oberfläche. Bei polaren Flüssigkeiten, wie zum Beispiel Wasser, wird ein großer Kontaktwinkel erwartet.

Tabelle 11 zeigt den Kontaktwinkel eines Wassertropfens an Druckplatten mit oder ohne MOA an der Klischeeoberfläche. Die Anwesenheit des MOA wurde über die Nachbelichtung gesteuert. Als Referenz diente das reine MOA.

Tabelle 11:

| Beispiel | %UVA PI | %UVC PI | Belichtung | Dosis UVA (mJ/cm$^2$) | Dosis UVC (mJ/cm$^2$) | UVA/ UVC | Kontakt -winkel $\theta$/° |
|---|---|---|---|---|---|---|---|
| Referenz 10a | - | - | - | - | - | - | 97,9 |
| Beispiel 10b | 2 | 0 | 10A | 6600 | 0 | >100 | 86,7 |
| Beispiel 10c | 2 | 0 | 10A10Cp | 6600 | 7800 | 0,8 | 78,0 |
| Beispiel 10d | 2 | 1 | 5C | 0 | 7800 | 0 | 89,1 |
| Beispiel 10e | 2 | 1 | 10A10Cp | 6600 | 7800 | 0,8 | 64,1 |
| Beispiel 10f | 5 | 0,5 | 5C | 0 | 7800 | 0 | 97,9 |
| Beispiel 10g | 5 | 0,5 | 10A10Cp | 6600 | 7800 | 0,8 | 84,5 |

Die Anwesenheit des MOA auf der Oberfläche beeinflusst die Benetzung der Oberfläche mit Wasser. Bei Anwesenheit des MOA auf der Druckplattenoberfläche ist der Kontaktwinkel des Wassertropfens deutlich größer als bei einer Oberfläche ohne MOA. Bei Anwesenheit des MOA auf der Klischeeoberfläche (Beispiele 10b, 10d und 10f), nähert sich der eingenommene Kontaktwinkel des Wassertropfens dem des reinen MOA (Referenz 10a) an. Die Photoinitiatorkonzentration wirkt sich insbesondere auf den Kontaktwinkel in Abwesenheit des MOA aus. Mit 1% UVC PI (Beispiel 10e) wurde ein niedrigerer Kontaktwinkel erhalten als ohne (Beispiel 10c). Beim Druck mit wasserbasierter Farbe kann die Anwesenheit des MOA folglich zu Benetzungsstörungen führen. Eine Steuerung der Migration des MOA ist durch die Nachbelichtung möglich.

Beispiel 11:

Ein SBS-basierter Reliefvorläufer (Gesamtdicke 1,14 mm) wurde mit 1 Gew% eines Paraffin-Wachses (>C20) mit einem Schmelzpunkt von 50-57°C als MOA und 5 Gew% Benzil-a,a-dimethylacetal (IGM Resins B.V.) auf einem Polyesterträger hergestellt. Der Reliefvorläufer wurde mittels der Fluoreszenzröhren (Philips TL 80W/10-R) in einem nyloflex® Combi FIII-Belichter (Flint Group) für 18 Sekunden mit einer Intensität von 16 mW/cm$^2$ von der Rückseite belichtet. Nach Abziehen der Schutzfolie wurde der Vorläufer in einem ThermoFlexX 20 (Xeikon) bebildert und anschließend in einem nyloflex® Combi FIII-Belichter (Flint Group) mittels der Fluoreszenzröhren (Philips TL 80W/10-R) für 15 Minuten mit einer Intensität von 16 mW/cm$^2$ bei 40°C durch die Maskenschicht belichtet. Der belichtete Vorläufer wurde in einem nyloflex® Digital Washer FIII (Flint Group) mittels nylosolv A und bei einer Geschwindigkeit von 220 mm/min ausgewaschen. Die Trocknung erfolgte über 120 Minuten bei 60°C. Anschließend wurde die Druckplatte für 10 min mit UVA-Licht (Philips TL 60W/10-R, Intensität 11 mW/cm$^2$) und für 5 min mit UVC-Licht (Philips TUV 75W HO G75 T8,

Intensität 13 mW/cm$^2$) in einem nyloflex® Combi FIII-Belichter nachbelichtet. Beide Belichtungen (UVA und UVC) wurden zur selben Zeit gestartet und bei jeweils 40°C durchgeführt. Nach mind. einer Woche Lagerzeit nach Entwicklung der Druckplatten wurden an den gebildeten Druckflächen Kontaktwinkelmessungen durchgeführt. Als Referenz diente eine Fläche aus reinem MOA, die durch Aufschmelzen und erkalten desselbigen erhalten wurde.

Tabelle 12:

| Beispiel | %MOA | Belichtung | Dosis UVA (mJ/cm$^2$) | Dosis UVC (mJ/cm$^2$) | UVA / UVC | Kontaktwinkel $\theta$ /° |
|---|---|---|---|---|---|---|
| Referenz 11a | 100 | - | - | - | - | 97,9 |
| Beispiel 11b | 1 | 10A5C | 6600 | 3900 | 1,7 | 94,2 |
| Beispiel 11c | 0 | 10A5C | 6600 | 3900 | 1,7 | 80,5 |

Ist das MOA an der Druckplattenoberfläche vorhanden (Beispiel 11b), nähert sich der Kontaktwinkel dem auf reinem MOA (Referenz 11a) an. Ohne MOA auf der Plattenoberfläche (Beispiel 11c) erhält man bei sonst gleichen Verarbeitungsbedingungen einen deutlich geringeren Kontaktwinkel.

**Patentansprüche**

1. Fotopolymerisierbarer Reliefvorläufer umfassend

   (A) einen dimensionsstabilen Träger,
   (B) eine fotopolymerisierbare reliefbildende Schicht, mindestens enthaltend ein vernetzbares elastomeres Bindemittel, ein ethylenisch ungesättigtes Monomer, ein migrationsfähiges, oberflächenaktives Additiv, einen mit UVA-Licht aktivierbaren Photoinitiator und einen mit UVC-Licht aktivierbaren Photoinitiator.

2. Fotopolymerisierbarer Reliefvorläufer nach Anspruch 1, **dadurch gekennzeichnet, dass** das migrationsfähige, oberflächenaktive Additiv ausgewählt ist aus der Gruppe bestehend aus ionischen oder nichtionischen Tensiden, langkettigen Kohlenwasserstoffen, Wachsen, insbesondere Paraffinwachsen, Organosiliziumverbindungen, insbesondere Silikonölen, Silanen und Siloxanen, oder deren Gemischen.

3. Fotopolymerisierbarer Reliefvorläufer nach Anspruch 1 oder 2, **dadurch gekennzeichnet, dass** das migrationsfähige, oberflächenaktive Additiv ein Paraffinwachs ist.

4. Fotopolymerisierbarer Reliefvorläufer nach einem der Ansprüche 1 bis 3, **dadurch gekennzeichnet, dass** der mit UVA-Licht aktivierbare Photoinitiator ausgewählt ist aus der Gruppe bestehend aus Benzilketalen, Acylphosphinoxiden, Bisacylphosphinoxiden, Aminophenylketonen, Phenyloximester und deren Gemischen.

5. Fotopolymerisierbarer Reliefvorläufer nach einem der Ansprüche 1 bis 4, **dadurch gekennzeichnet, dass** der mit UVC-Licht aktivierbare Photoinitiator ausgewählt ist aus der Gruppe bestehend aus Hydroxyphenylketonen, Benzoylfomiaten, Benzophenonen, Arylalkylketonen, Arylbenzylketonen und deren Gemischen.

6. Fotopolymerisierbarer Reliefvorläufer nach Anspruch 4 oder 5, **dadurch gekennzeichnet, dass** der mit UVA-Licht aktivierbare Photoinitiator ausgewählt ist aus der Gruppe bestehend aus Diphenyl(2,4,6-trimethylbenzoyl)phosphinoxid, Benzildimethylketal und Benzildiethylketal und der mit UVC-Licht aktivierbare Photoinitiator ausgewählt ist aus der Gruppe bestehend aus Oxyphenylessigsäure 2-[2-oxo-2-phenyl-acetoxy-ethoxy]ethylester, Oxyphenylessigsäure 2-[2-hydroxy-ethoxy]ethylester, Methylbenzoylformiat, p-Tolylundecylketon, 1-Hydroxycyclohexylphenylketon und 2-Hydroxy-2-methyl-1-phenylpropan-1-on und deren Gemischen.

7. Fotopolymerisierbarer Reliefvorläufer nach einem der Ansprüche 1 bis 6, **dadurch gekennzeichnet, dass** die fotopolymerisierbare reliefbildende Schicht das migrationsfähige, oberflächenaktive Additiv in einer Menge von 0,1 bis 10 Gew.-%, bevorzugt 0,2 bis 5 Gew.-%, besonders bevorzugt 0,5 bis 1,5 Gew.-%, bezogen auf das Gewicht der fotopolymerisierbaren, reliefbildenden Schicht, enthält.

8. Fotopolymerisierbarer Reliefvorläufer nach einem der Ansprüche 1 bis 7, **dadurch gekennzeichnet, dass** die fotopolymerisierbare reliefbildende Schicht den mit UVA-Licht aktivierbaren Photoinitiator in einer Menge von 0,5 bis 20 Gew.-%, bevorzugt von 0,5 bis 15 Gew.-%, besonders bevorzugt von 0,5 bis 10 Gew.-%, ganz besonders bevorzugt von 0,5 bis 6 Gew.-%, bezogen auf die Gesamtmenge der fotopolymerisierbaren, reliefbildenden Schicht, enthält.

9. Fotopolymerisierbarer Reliefvorläufer nach einem der Ansprüche 1 bis 8, **dadurch gekennzeichnet, dass** die fotopolymerisierbare reliefbildende Schicht den mit UVC-Licht aktivierbaren Photoinitiator in einer Konzentration von 0,1 bis 20 Gew.-%, bevorzugt von 0,1 bis 10 Gew.-%, besonders bevorzugt von 0,5 bis 5 Gew.-%, ganz besonders bevorzugt von 0,25 bis 3 Gew.-%, bezogen auf die Gesamtmenge der fotopolymerisierbaren, reliefbildenden Schicht, enthält.

10. Fotopolymerisierbarer Reliefvorläufer nach einem der Ansprüche 1 bis 9, **dadurch gekennzeichnet, dass** das Massenverhältnis von mit UVA-Licht aktivierbarem Photoinitiator zu mit UVC-Licht aktivierbarem Photoinitiator von 0,1 bis 50, bevorzugt von 0,5 bis 40, besonders bevorzugt von 0,5 bis 30, ganz besonders bevorzugt von 0,5 bis 15, beträgt.

11. Verfahren zur Herstellung einer Reliefstruktur mit den Schritten:

(i) Bereitstellen eines fotopolymerisierbaren Reliefvorläufers enthaltend mindestens ein migrationsfähiges, oberflächenaktives Additiv,
(ii) Aufbringen einer Maske oder Erzeugung einer strukturierten Maskenschicht oberhalb der fotopolymerisierbaren reliefbildenden Schicht,
(iii) optional Rückseitenvorbelichtung mit elektromagnetischer Strahlung durch die Trägerschicht,
(iv-a) Belichtung der fotopolymerisierbaren reliefbildenden Schicht mit elektromagnetischer Strahlung durch die Maske oder Maskenschicht hindurch,
(v) Entfernung der Maske oder der Maskenschicht, gegebenenfalls vorhandener weiterer Schichten und der in Schritt (iv-a) nicht belichteten, nicht fotopolymerisierten Bereiche der reliefbildenden Schicht, wobei ein Relief erzeugt wird,
(vi) optional Trocknung des Reliefs,
(vii) Nachbelichtung des Reliefs von der der Trägerschicht abgewandten Seite mit UVA-Licht im Wellenlängenbereich von 315 bis 380 nm und/oder mit UVC-Licht im Wellenlängenbereich von 200 bis 280 nm, wobei das Relief nachvernetzt und dessen Durchlässigkeit für das migrationsfähige oberflächenaktive Additiv eingestellt wird, zur Einstellung der Oberflächenbeschaffenheit des Reliefs,
(viii) optional weitere Behandlungsschritte.

12. Verfahren zur Herstellung einer Reliefstruktur mit den Schritten:

(i) Bereitstellen eines fotopolymerisierbaren Reliefvorläufers enthaltend mindestens ein migrationsfähiges, oberflächenaktives Additiv,
(iii) optional Rückseitenvorbelichtung mit elektromagnetischer Strahlung durch die Trägerschicht,
(iv-b) bildgebende Belichtung der fotopolymerisierbaren reliefbildenden Schicht mit elektromagnetischer Strahlung
(v) Entfernung gegebenenfalls vorhandener weiterer Schichten und der in Schritt (iv) nicht belichteten, nicht fotopolymerisierten Bereiche der reliefbildenden Schicht, wobei eine Relief erzeugt wird,
(vi) optional Trocknung des Reliefs,
(vii) Nachbelichtung des Reliefs von der der Trägerschicht abgewandten Seite mit UVA-Licht im Wellenlängenbereich von 315 bis 380 nm und/oder mit UVC-Licht im Wellenlängenbereich von 200 bis 280 nm, wobei das Relief nachvernetzt und dessen Durchlässigkeit für das migrationsfähige oberflächenaktive Additiv eingestellt wird, zur Einstellung der Oberflächenbeschaffenheit des Reliefs,
(viii) optional weitere Behandlungsschritte.

13. Verfahren nach Anspruch 11 oder 12, **dadurch gekennzeichnet, dass** in Schritt (vii) mit UVA-Licht und UVC-Licht nachbelichtet wird, wobei die Nachbelichtung mit UVA-Licht und UVC-Licht gleichzeitig, nacheinander oder abwechselnd erfolgt.

14. Verfahren nach einem der Ansprüche 11 bis 13 zur Herstellung einer optimierten Reliefstruktur, **dadurch gekennzeichnet, dass** das Verfahren mit den Schritten (i) bis (viii) mehrfach durchgeführt wird, wobei in Schritt (vii) die Nachbelichtung mit UVA-Licht und/oder UVC-Licht hinsichtlich der Dosis und/oder der zeitlichen Abfolge der UVA- und UVC-Nachbelichtungsschritte variiert wird, um die Oberflächenbeschaffenheit des Reliefs zu optimieren.

15. Reliefstruktur, erhältlich nach dem Verfahren gemäß einem der Ansprüche 11 bis 14.

16. Verwendung der Reliefstruktur nach Anspruch 15 als Tampondruckplatte, Flexodruckplatte, Buchdruckplatte, Tiefdruckplatte, mikrofluidisches Bauteil, Mikroreaktor, phoretische Zelle, photonischer Kristall oder optisches Bauteil.

Figur 1

Glanz 3 min UVC

Figur 2

Glanz 10 min UVC

Legend: i) 0A 10C simultan; j) 2A 10C simultan; k) 5A 10C simultan; l) 10A 10C simultan. Y-axis: Glanz / GU (0–50). X-axis: Zeit / Tage (0–7).

Figur 3

Figur 4

Figur 5

IR - 7 Tage - 10 min UVC

Nachbelichtung min UVA|| min UVC simultan

Figur 6

Europäisches
Patentamt

European
Patent Office

Office européen
des brevets

**EUROPÄISCHER RECHERCHENBERICHT**

Nummer der Anmeldung

EP 19 21 5470

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 014 194 A1 (BASF DRUCKSYSTEME GMBH [DE]) 28. Juni 2000 (2000-06-28) * Absätze [0001], [0055], [0061], [0070] - [0076]; Ansprüche 1, 2, 8, 9; Beispiel 1 * ----- | 11-13, 15,16 | INV. G03F7/004 G03F7/027 G03F7/029 G03F7/031 G03F7/095 G03F7/20 |
| A | WO 2019/072701 A1 (FLINT GROUP GERMANY GMBH [DE]) 18. April 2019 (2019-04-18) * Ansprüche 1, 19,22; Beispiel 1 * ----- | 11-16 | |
| A | WO 2018/177500 A1 (FLINT GROUP GERMANY GMBH [DE]) 4. Oktober 2018 (2018-10-04) * Ansprüche 1-17; Beispiele 2B, 3B, 3C * ----- | 1-16 | |

**RECHERCHIERTE SACHGEBIETE (IPC)**

G03F

Der vorliegende Recherchenbericht wurde für alle Patentansprüche erstellt

| Recherchenort | Abschlußdatum der Recherche | Prüfer |
|---|---|---|
| München | 24. Juni 2020 | Eggers, Karin |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

                                   
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 21 5470

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-06-2020

| Im Recherchenbericht angeführtes Patentdokument | Datum der Veröffentlichung | Mitglied(er) der Patentfamilie | Datum der Veröffentlichung |
|---|---|---|---|
| EP 1014194 A1 | 28-06-2000 | DE 19859623 A1 | 24-08-2000 |
| | | EP 1014194 A1 | 28-06-2000 |
| | | JP 2000194138 A | 14-07-2000 |
| | | US 6355395 B1 | 12-03-2002 |
| WO 2019072701 A1 | 18-04-2019 | KEINE | |
| WO 2018177500 A1 | 04-10-2018 | CN 110678332 A | 10-01-2020 |
| | | EP 3598870 A1 | 29-01-2020 |
| | | JP 2020515431 A | 28-05-2020 |
| | | US 2020055303 A1 | 20-02-2020 |
| | | WO 2018177500 A1 | 04-10-2018 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3045516
- EP 0085472 A
- DE 1522444
- EP 0079514 A
- EP 0224164 A
- EP 0059988 A
- EP 1239329 A
- EP 1170121 A